# EUROPEAN PATENT APPLICATION

(11) **EP 4 276 905 A1**
(43) Date of publication of application: **15.11.2023**
(21) Application number: 21917687.2
(22) Date of filing: 22.12.2021
(51) Int. Cl.: H01L 27/146, H04N 5/3745

(54) **LIGHT-RECEIVING ELEMENT AND RANGING SYSTEM**

(30) Priority: 06.01.2021 JP 2021000770
(71) Applicant: Sony Semiconductor Solutions Corporation, Atsugi-shi, Kanagawa 243-0014 (JP)
(72) Inventor: SHIMADA, Shohei, Atsugi-shi, Kanagawa 243-0014 (JP); HIYAMA, Hiroki, Atsugi-shi, Kanagawa 243-0014 (JP)
(74) Representative: Müller Hoffmann & Partner
(86) International application number: PCT/JP2021/047513
(87) International publication number: WO 2022/149467

(57) **Abstract**

The present disclosure relates to a light receiving element and a ranging system capable of reducing a pixel size in a stack-type light receiving element using an avalanche photodiode.

The light receiving element includes: a first substrate on which an avalanche photodiode that converts received light into an electric signal and at least one element are formed, the element being included in a read circuit which outputs a pixel signal on the basis of the electric signal; and a second substrate on which a logic circuit is formed, the logic circuit being a circuit that processes the pixel signal which is read from the avalanche photodiode, and the first substrate and the second substrate being stacked. The technique of the present disclosure can be applied to, for example, a light receiving element, a ranging system, or the like that detects a distance to a subject.

## Description

### TECHNICAL FIELD

The present disclosure relates to a light receiving element and a ranging system, and more particularly, to a light receiving element and a ranging system capable of reducing a pixel size in a stack-type light receiving element using an avalanche photodiode.

### BACKGROUND ART

In recent years, a light receiving element that measures a distance by a Time-of-Flight (ToF) method has attracted attention. Such light receiving elements include a light receiving element using a single photon avalanche diode (SPAD) as a light receiving pixel. In the SPAD, avalanche amplification occurs in a case where one photon enters a PN junction region having a high electric field in a state where a voltage higher than a breakdown voltage (hereinafter, referred to as excess bias) is applied. By detecting a timing at which current instantaneously flows by the avalanche amplification, a distance can be measured with high accuracy.

The light receiving elements using the SPAD include a light receiving element obtained by stacking two semiconductor substrates of a first semiconductor substrate on which an SPAD is formed and a second semiconductor substrate on which a logic circuit is formed (refer to, for example, Patent Document 1).

### CITATION LIST

### PATENT DOCUMENT

Patent Document 1: US Patent Application Publication No. 2015/0200314 Specification

### SUMMARY OF THE INVENTION

### PROBLEMS TO BE SOLVED BY THE INVENTION

In the related art, in a stack-type light receiving element using the SPAD, as in the configuration disclosed in Patent Document 1, only the SPAD is disposed on the first semiconductor substrate, and all read circuits that read a signal of the SPAD are formed on the second semiconductor substrate side. The read circuit includes a high-voltage transistor for applying an excess bias to the SPAD, and thus there is a limit to reduce a circuit area per pixel.

The present disclosure has been made in view of such a situation, and an object of the present disclosure is to reduce a pixel size in a stack-type light receiving element using an avalanche photodiode.

### SOLUTIONS TO PROBLEMS

According to a first aspect of the present disclosure, there is provided a light receiving element including: a first substrate on which an avalanche photodiode that converts received light into an electric signal and at least one element are formed, the element being included in a read circuit which outputs a pixel signal on the basis of the electric signal; and a second substrate on which a logic circuit is formed, the logic circuit being a circuit that processes the pixel signal which is read from the avalanche photodiode, the first substrate and the second substrate being stacked.

According to a second aspect of the present disclosure, there is provided a ranging system including: a lighting device that emits irradiation light; and a light receiving element that receives reflected light of the irradiation light, the reflected light being obtained by being reflected by a predetermined object, in which the light receiving element includes a first substrate on which an avalanche photodiode that converts received light into an electric signal and at least one element are formed, the element being included in a read circuit which outputs a pixel signal on the basis of the electric signal, and a second substrate on which a logic circuit is formed, the logic circuit being a circuit that processes the pixel signal which is read from the avalanche photodiode, the first substrate and the second substrate being stacked.

In the first and second aspects of the present disclosure, a first substrate on which an avalanche photodiode that converts received light into an electric signal and at least one element are formed, and a second substrate on which a logic circuit is formed are stacked, the element being included in a read circuit which outputs a pixel signal on the basis of the electric signal, and the logic circuit being a circuit that processes the pixel signal which is read from the avalanche photodiode.

The light receiving element and the ranging system may be independent devices, or may be modules incorporated in other devices.

### BRIEF DESCRIPTION OF DRAWINGS

Fig. 1 is a diagram illustrating a circuit example of an SPAD pixel as a comparative example.
Fig. 2 is a diagram illustrating an operation of the SPAD pixel of Fig. 1.
Fig. 3 is a cross-sectional view of the SPAD pixel of Fig. 1.
Fig. 4 is a diagram illustrating a circuit example of an SPAD pixel according to a first embodiment of the present disclosure.
Fig. 5 is a cross-sectional view of the SPAD pixel according to the first embodiment.
Fig. 6 is a plan view of a sensor-side wiring layer of Fig. 5.
Fig. 7 is a cross-sectional view of an SPAD pixel according to a second embodiment of the present disclosure.
Fig. 8 is a diagram illustrating a circuit example of the SPAD pixel according to the second embodiment.
Fig. 9 is a plan view of a sensor-side wiring layer of Fig. 7.
Fig. 10 is a diagram illustrating a circuit example of an SPAD pixel according to a third embodiment of the present disclosure.
Fig. 11 is a cross-sectional view of the SPAD pixel according to the third embodiment.
Fig. 12 is a diagram illustrating a circuit example of an SPAD pixel according to a fourth embodiment of the present disclosure.
Fig. 13 is a cross-sectional view of the SPAD pixel according to the fourth embodiment.
Fig. 14 is a diagram illustrating a circuit example of an SPAD pixel according to a fifth embodiment of the present disclosure.
Fig. 15 is a cross-sectional view of the SPAD pixel according to the fifth embodiment.
Fig. 16 is a diagram illustrating a circuit example of an SPAD pixel according to a sixth embodiment of the present disclosure.
Fig. 17 is a cross-sectional view of the SPAD pixel according to the sixth embodiment.
Fig. 18 is a diagram illustrating a circuit example of an SPAD pixel according to a seventh embodiment of the present disclosure.
Fig. 19 is a cross-sectional view of the SPAD pixel according to the seventh embodiment.
Fig. 20 is a diagram illustrating a circuit example of an SPAD pixel according to an eighth embodiment of the present disclosure.
Fig. 21 is a cross-sectional view of the SPAD pixel according to the eighth embodiment.
Fig. 22 is a diagram illustrating a circuit example of an SPAD pixel according to a ninth embodiment of the present disclosure.
Fig. 23 is a cross-sectional view of the SPAD pixel according to the ninth embodiment.
Fig. 24 is a plan view of a sensor-side wiring layer of Fig. 23.
Fig. 25 is a diagram illustrating a circuit example of an SPAD pixel according to a tenth embodiment of the present disclosure.
Fig. 26 is a cross-sectional view of the SPAD pixel according to the tenth embodiment.
Fig. 27 is a cross-sectional view illustrating a detailed configuration example of a sensor-side wiring layer of the SPAD pixel of Fig. 3.
Fig. 28 is a cross-sectional view illustrating a detailed configuration example of a sensor-side wiring layer in a case where a resistor is formed on a pixel substrate side.
Fig. 29 is a cross-sectional view illustrating a detailed configuration example of a sensor-side wiring layer in a case where a polysilicon TFT is formed on a pixel substrate side.
Fig. 30 is a cross-sectional view illustrating a detailed configuration example of a sensor-side wiring layer in a case where a diode, a resistor, and a MOS transistor are formed on a pixel substrate side.
Fig. 31 is a cross-sectional view illustrating a detailed configuration example of a sensor-side wiring layer including a source and a drain of the MOS transistor of Fig. 30.
Fig. 32 is a block diagram illustrating a configuration example of a ranging system according to an embodiment of the present disclosure.
Fig. 33 is a block diagram illustrating a schematic configuration example of a light receiving element of Fig. 32.
Fig. 34 is a block diagram illustrating an example of a schematic configuration of a vehicle control system.
Fig. 35 is an explanatory diagram illustrating an example of installation positions of an outside-vehicle information detecting section and an imaging section.

### MODE FOR CARRYING OUT THE INVENTION

Hereinafter, modes for carrying out the technique of the present disclosure (hereinafter, referred to as embodiments) will be described with reference to the accompanying drawings. Note that a description will be given in the following order.
1. Comparative Example of SPAD Pixel
2. First Embodiment of SPAD Pixel
3. Second Embodiment of SPAD Pixel
4. Third Embodiment of SPAD Pixel
5. Fourth Embodiment of SPAD Pixel
6. Fifth Embodiment of SPAD Pixel
7. Sixth Embodiment of SPAD Pixel
8. Seventh Embodiment of SPAD Pixel
9. Eighth Embodiment of SPAD Pixel
10. Ninth Embodiment of SPAD Pixel
11. Tenth Embodiment of SPAD Pixel
12. Detailed Configuration Example of Sensor-side Wiring Layer
13. Summary of Embodiments of SPAD Pixel
14. Configuration Example of Ranging System
15. Application Example to Moving Object

Note that, in the drawings referred to in the following description, the same or similar portions are denoted by the same or similar reference numerals. Note that, the drawings are schematic, and a relationship between a thickness and a planar dimension, a ratio of the thicknesses between respective layers and the like are different from actual ones. In addition, the drawings may include portions having different dimensional relationships and ratios.

Further, definition of directions such as upward and downward directions in the following description is merely the definition for convenience of description, and does not limit the technical idea of the present disclosure. For example, when an object is observed by rotating the object by 90°, the up and down are converted into and read as left and right, and when the object is observed by rotating the object by 180°, the up and down are inverted and read.

The technique of the present disclosure can be applied to, for example, a light receiving element such as a ranging sensor that performs distance measurement by a time-of-flight (ToF) method. For example, the technique of the present disclosure can be applied to an avalanche photodiode (APD) that converts received light into an electric signal. An avalanche photodiode (APD) has a Geiger mode in which the avalanche photodiode is operated at a bias voltage higher than a breakdown voltage (hereinafter, referred to as an excess bias) and a linear mode in which the avalanche photodiode is operated at a slightly higher bias voltage near the breakdown voltage. The Geiger mode avalanche photodiode is also referred to as a single photon avalanche diode (SPAD). The SPAD can instantaneously detect one photon by multiplying a carrier generated by photoelectric conversion in a PN junction region having a high electric field (multiplication region).

Hereinafter, a case where the technique of the present disclosure is applied to the SPAD will be described as an example. Note that, in the following description, a pixel including the SPAD will be referred to as an SPAD pixel.

### <1. Comparative Example of SPAD Pixel>

First, in order to facilitate understanding of the technique of the present disclosure, a configuration of an SPAD pixel will be described as a comparative example compared with a pixel structure of the present disclosure.

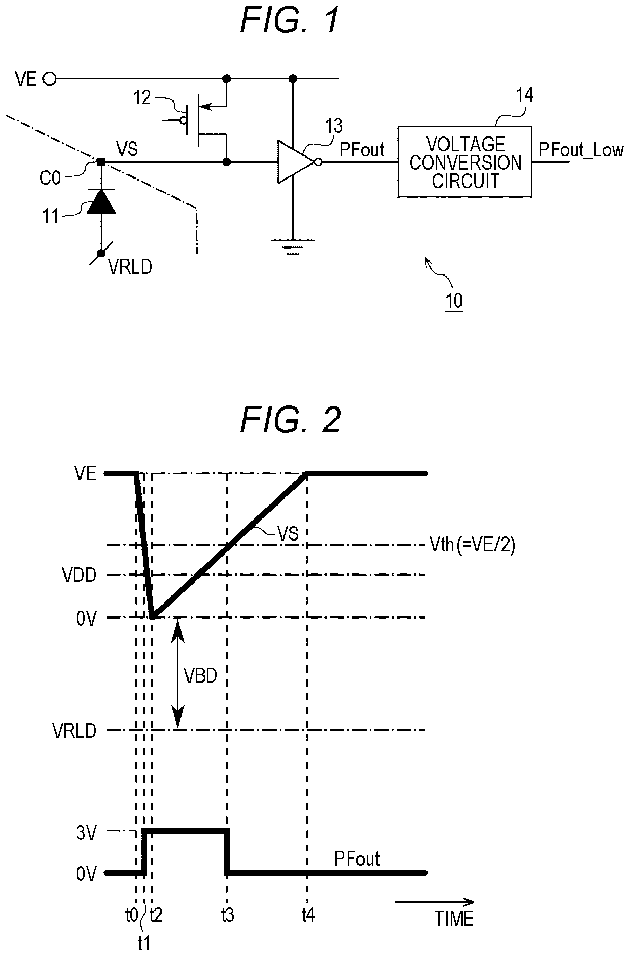

Fig. 1 illustrates a circuit example of an SPAD pixel as a comparative example.

The SPAD pixel 10 in Fig. 1 includes an SPAD 11, a MOS transistor 12, an inverter 13, and a voltage conversion circuit 14.

A cathode of the SPAD 11 is connected to a drain of the MOS transistor 12, and is connected to an input terminal of the inverter 13. An anode of the SPAD 11 is connected to a power supply voltage VRLD (hereinafter, also referred to as an anode voltage VRLD).

The SPAD 11 is a photodiode (single photon avalanche photodiode) that performs avalanche amplification of generated electrons and outputs an electric signal of a cathode voltage VS when incident light is incident. The power supply voltage VRLD supplied to the anode of the SPAD 11 is, for example, a negative bias (negative potential) having the same voltage as the breakdown voltage VBD of the SPAD 11. Specifically, in a case where the breakdown voltage VBD of the SPAD 11 is 20 V, the power supply voltage VRLD is -20 V.

The MOS transistor 12 is, for example, a P-type MOSFET that operates in a saturation region, and performs passive quenching by acting as a quenching resistor. A source of the MOS transistor 12 is connected to a power supply voltage VE, and the drain of the MOS transistor 12 is connected to the cathode of the SPAD 11 and the input terminal of the inverter 13. Therefore, the power supply voltage VE is also supplied to the cathode of the SPAD 11. Note that a pull-up resistor can also be used instead of the MOS transistor 12 connected in series with the SPAD 11.

In order to detect light (photon) with sufficient efficiency, an excess bias higher than the breakdown voltage VBD of the SPAD 11 is applied to the SPAD 11. For example, in a case where the breakdown voltage VBD of the SPAD 11 is 20 V and a voltage higher than the breakdown voltage VBD of the SPAD 11 by 3 V is applied, the power supply voltage VE supplied to the source of the MOS transistor 12 is 3 V.

The inverter 13 outputs a signal PFout in a Hi state when a cathode voltage VS as an input signal is in a Lo state, and outputs a signal PFout in a Lo state when the cathode voltage VS is in a Hi state.

The voltage conversion circuit 14 converts the signal PFout which is input from the inverter 13 into a low-voltage signal PFout_Low and outputs the low-voltage signal PFout_Low. For example, the signal PFout which is input from the inverter 13 is a signal having a voltage amplitude of 0 V to 3 V, and the voltage conversion circuit 14 converts the signal PFout having a voltage amplitude of 0 V to 3 V into a signal PFout_Low having a voltage amplitude of 0 V to 1 V.

A read circuit is configured with the MOS transistor 12, the inverter 13, and the voltage conversion circuit 14. The read circuit reads, as a pixel signal, the cathode voltage VS of the SPAD 11, and outputs the pixel signal to a logic circuit at a subsequent stage.

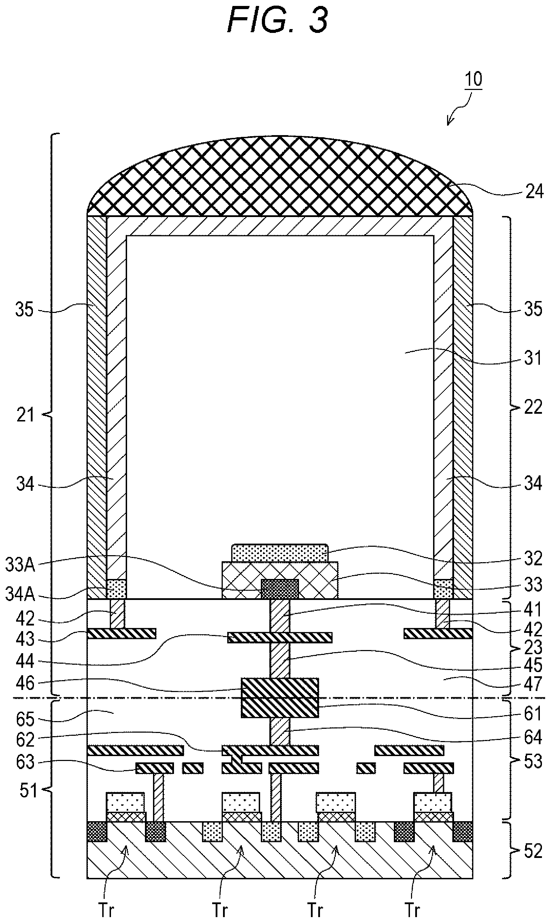

A boundary indicated by a one-dot chain line in Fig. 1 represents a bonding surface between a first substrate 21 and a second substrate 51 in a pixel structure of the SPAD pixel 10 illustrated in Fig. 3. A contact point C0 represents a connection portion where wiring of the first substrate 21 and wiring of the second substrate 51 are electrically connected to each other by metal bonding such as Cu-Cu bonding.

Next, an operation of the SPAD pixel 10 will be described with reference to Fig. 2. Fig. 2 is a graph illustrating a change in the cathode voltage VS of the SPAD 11 in response to incidence of photons and a detection signal PFout.

At a timing before a timing t0 in Fig. 2, the power supply voltage VE is supplied to the cathode of the SPAD 11, and the power supply voltage VRLD is supplied to the anode of the SPAD 11. Thus, a reverse voltage larger than the breakdown voltage VBD is applied to the SPAD 11. Therefore, the SPAD 11 is set to the Geiger mode. In this state, the cathode voltage VS of the SPAD 11 is the same as the power supply voltage VE.

In a case where photons are incident on the SPAD 11 which is set to the Geiger mode, avalanche multiplication occurs, and a current flows through the SPAD 11.

In a case where, at the timing t0, avalanche multiplication occurs and a current flows through the SPAD 11, after the timing t0, a current also flows through the MOS transistor 12 as a constant current source, and a voltage drop occurs due to a resistance component of the MOS transistor 12.

In a case where, at a timing t2, the cathode voltage VS of the SPAD 11 becomes lower than 0 V, the cathode voltage VS becomes lower than the breakdown voltage VBD. Thus, the avalanche amplification stops. Here, an operation of stopping the avalanche amplification by making the voltage drop occur by allowing the current generated by the avalanche amplification to flow through the MOS transistor 12 as the constant current source and making the cathode voltage VS lower than the breakdown voltage VBD due to the occurred voltage drop is a quenching operation.

In a case where the avalanche amplification stops, the current flowing through the MOS transistor 12 gradually decreases, and at a timing t4, the cathode voltage VS returns to the original power supply voltage VE again. Thus, the SPAD 11 enters a state in which a next new photon can be detected (recharge operation).

The inverter 13 outputs the PFout signal in a low (Lo) state when the cathode voltage VS, which is an input voltage, is equal to or higher than a predetermined threshold voltage Vth (= VE/2), and outputs the PFout signal in a Hi state when the cathode voltage VS is lower than the predetermined threshold voltage Vth. In the example of Fig. 2, the PFout signal in a high (Hi) state is output in a period from the timing t1 to the timing t3.

Fig. 3 illustrates a cross-sectional view of the SPAD pixel 10 of Fig. 1.

As illustrated in Fig. 3, the SPAD pixel 10 is configured by bonding a first substrate 21 and a second substrate 51. A one-dot chain line in Fig. 3 corresponds to the one-dot chain line in Fig. 1, and indicates the bonding surface between the first substrate 21 and the second substrate 51. In the following description, for easy understanding of the description, the first substrate 21 is referred to as a pixel substrate 21, and the second substrate 51 is referred to as a logic substrate 51, as appropriate.

The pixel substrate 21 includes a semiconductor substrate 22 including silicon or the like, a wiring layer 23, and an on-chip lens 24. Hereinafter, the wiring layer 23 of the pixel substrate 21 is referred to as a sensor-side wiring layer 23 in order to facilitate distinction from a wiring layer 53 of the logic substrate 51 to be described later, and the wiring layer 53 of the logic substrate 51 is referred to as a logic-side wiring layer 53. The sensor-side wiring layer 23 of the pixel substrate 21 and the logic-side wiring layer 53 of the logic substrate 51 are bonded so as to face each other. A surface on which the sensor-side wiring layer 23 is formed with respect to the semiconductor substrate 22 is a front surface of the semiconductor substrate 22. In Fig. 3, a surface on which the on-chip lens 24 is formed and which is on an upper side is a back surface of the semiconductor substrate 22, and is a light receiving surface on which light is incident.

In the semiconductor substrate 22, an N-well 31, a P-type diffusion layer 32, an N-type diffusion layer 33, and a hole accumulation layer 34 are formed inside a pixel isolation portion 35. The pixel isolation portion 35 is disposed at a pixel boundary portion which is a boundary with an adjacent pixel in a plan view.

The N-well 31 is formed by controlling the semiconductor substrate 22 to an N-type in which an impurity concentration is low, and forms an electric field for transferring electrons generated by photoelectric conversion in the SPAD pixel 10 to an avalanche multiplication region. Note that, instead of the N-well 31, a P-well may be formed by controlling the semiconductor substrate 22 to a P-type in which an impurity concentration is low.

The P-type diffusion layer 32 is a P-type diffusion layer which has a high concentration and is formed in a rectangular planar region inside the N-well 31. The N-type diffusion layer 33 is an N-type diffusion layer which has a high concentration and is formed in a rectangular planar region slightly wider than the planar region of the P-type diffusion layer 32. A part of the N-type diffusion layer 33 in the vicinity of the substrate front surface is formed at a higher concentration, and serves as a contact layer 33A connected to a contact electrode 41 as the cathode electrode for supplying a negative voltage to form an avalanche multiplication region. The avalanche multiplication region is formed by a depletion layer formed in the PN junction region in which the P-type diffusion layer 32 and the N-type diffusion layer 33 are bonded.

The hole accumulation layer 34 is a P-type diffusion layer formed so as to surround side surfaces and a bottom surface (a surface on a side of the on-chip lens 24) of the N-well 31, and accumulates holes. Further, a part of the hole accumulation layer 34 in the vicinity of the front surface is formed at a higher concentration, and serves as a contact layer 34A electrically connected to a contact electrode 42 as the anode electrode.

The pixel isolation portion 35 is formed at a boundary with an adjacent pixel, and is electrically isolated from another adjacent pixel. The pixel isolation portion 35 may be configured with, for example, only an insulating layer, or may have a double structure in which an outer side (N-well 31 side) of a metal layer such as tungsten (W), aluminum (Al), titanium (Ti), or titanium nitride (TiN) is covered with an insulating layer such as SiO2.

In the sensor-side wiring layer 23, the contact electrodes 41 and 42, the metal wirings 43 and 44, the contact electrode 45, and the metal wiring 46 are formed in an interlayer insulating film 47.

The contact electrode 41 as the cathode electrode connects the contact layer 33A and the metal wiring 44, and the contact electrode 45 connects the metal wiring 44 and the metal wiring 46. The metal wiring 46 is electrically and physically connected to the metal wiring 61 of the logic-side wiring layer 53 by metal bonding such as Cu-Cu. A metal bonding portion between the metal wiring 46 and the metal wiring 61 corresponds to the contact point C0 in Fig. 1.

The metal wiring 44 is formed to be wider than the avalanche multiplication region so as to cover the avalanche multiplication region in a plan view. In addition, the metal wiring 44 may have a structure in which light transmitted through a pixel region of the semiconductor substrate 22 is reflected toward the semiconductor substrate 22.

The metal wiring 43 is formed so as to overlap with the contact layer 34A in a plan view.

The contact electrode 42 as the anode electrode connects the contact layer 34A and the metal wiring 43. The metal wiring 43 is electrically connected to the metal wiring of the logic substrate 51 in a region (not illustrated), and the anode voltage VRLD supplied from the logic substrate 51 is supplied to the contact layer 34A via the metal wiring 43 and the contact electrode 42.

On the other hand, the logic substrate 51 includes a semiconductor substrate 52 including silicon or the like and a wiring layer 53 (logic-side wiring layer 53).

In Fig. 3, a plurality of MOS transistors Tr including the MOS transistor 12 as the constant current source and the MOS transistor included in the inverter 13 is formed on a front surface side of the semiconductor substrate 52 on an upper side.

In the logic-side wiring layer 53, metal wirings 61 to 63 and a contact electrode 64 are formed in an interlayer insulating film 65.

The metal wiring 61 is electrically and physically connected to the metal wiring 46 of the sensor-side wiring layer 23 by metal bonding such as Cu-Cu. The contact electrode 64 connects the metal wiring 61 and the metal wiring 62. The power supply voltage VE supplied to the contact electrode 41 as the cathode electrode is supplied to the metal wiring 46 of the sensor-side wiring layer 23 via the metal wiring 62, the contact electrode 64, and the metal wiring 61.

The logic-side wiring layer 53 includes at least twolayered metal wiring layers including a layer of the metal wiring 62 and a layer of the metal wiring 63 and an interlayer insulating film 65 between the layer of the metal wiring 62 and the layer of the metal wiring 63.

As described above, in the SPAD pixel 10 as the comparative example, only the SPAD 11 is formed on the pixel substrate 21, and the other circuits, for example, the MOS transistor 12, the inverter 13, and the voltage conversion circuit 14 are formed on the logic substrate 51 side. Since all the circuits other than the SPAD 11 are disposed on the logic substrate 51 side, there is a limit to reduce a circuit area per pixel.

### <2. First Embodiment of SPAD Pixel>

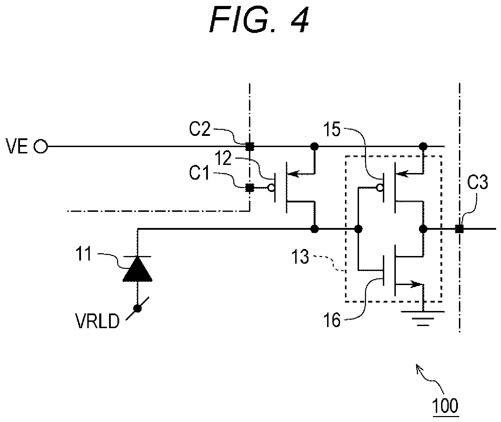

Fig. 4 illustrates a circuit example of an SPAD pixel according to a first embodiment of the present disclosure.

In Fig. 4, portions corresponding to the SPAD pixel 10 of Fig. 1 described as the comparative example are denoted by the same reference numerals, and description of the portions will be omitted as appropriate.

As illustrated in Fig. 4, the SPAD pixel 100 includes an SPAD 11, a MOS transistor 12, and an inverter 13, and the inverter 13 is specifically illustrated by a configuration of a MOS transistor 15 which is a P-type MOSFET and a MOS transistor 16 which is an N-type MOSFET. In addition, although not illustrated in Fig. 4, the SPAD pixel 100 also includes a voltage conversion circuit 14 at a subsequent stage of the inverter 13, similarly to the SPAD pixel 10 in Fig. 1. Therefore, the circuit configuration of the SPAD pixel 100 of Fig. 4 according to the first embodiment is the same as the circuit configuration of the SPAD pixel 10 of Fig. 1 according to the comparative example, and an operation of the SPAD pixel 100 is also the same as an operation of the SPAD pixel 10.

A difference between the SPAD pixel 100 of Fig. 4 according to the first embodiment and the SPAD pixel 10 of Fig. 1 according to the comparative example is a position of the one-dot chain line. In other words, circuit arrangement for two substrates of the pixel substrate 21 and the logic substrate 51 on which the SPAD pixel 100 is formed is different.

Specifically, in the SPAD pixel 10 of Fig. 1, only the SPAD 11 is formed on the pixel substrate 21 side, and the MOS transistor 12 and the inverter 13 are formed on the logic substrate 51 side.

On the other hand, in the SPAD pixel 100 of Fig. 4 according to the first embodiment, the SPAD 11, the MOS transistor 12, and the inverter 13 are formed on the pixel substrate 21 side. The pixel substrate 21 and the logic substrate 51 are electrically connected to each other at three contact points of contact points C1 to C3. The contact point C1 is a gate portion of the MOS transistor 12 as the constant current source, the contact point C2 is a supply portion of the power supply voltage VE, and the contact point C3 is an output portion of the inverter 13.

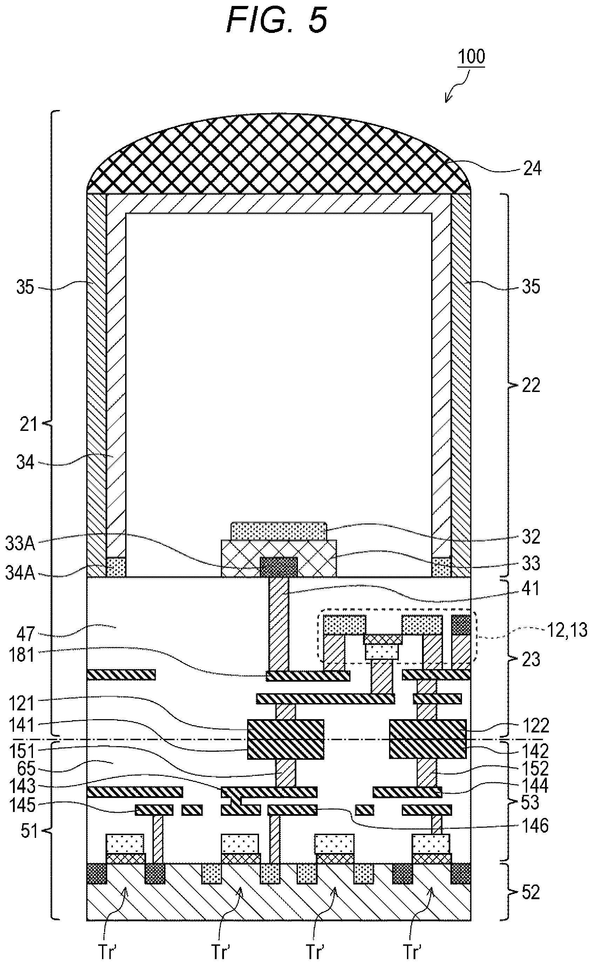

Fig. 5 is a cross-sectional view of the SPAD pixel according to the first embodiment.

In Fig. 5, portions corresponding to the SPAD pixel 10 of Fig. 3 described as the comparative example are denoted by the same reference numerals, and description of the portions will be omitted as appropriate. A one-dot chain line in Fig. 5 indicates a bonding surface between the pixel substrate 21 and the logic substrate 51.

Similarly to the SPAD pixel 10 of Fig. 3, the pixel substrate 21 includes a semiconductor substrate 22, a sensor-side wiring layer 23, and an on-chip lens 24. A configuration of the SPAD pixel 100 in the semiconductor substrate 22 is the same as the configuration of the SPAD pixel 10 of Fig. 3.

The SPAD pixel 100 of Fig. 5 is different from the SPAD pixel 10 of Fig. 4 in a configuration in the sensor-side wiring layer 23 between the semiconductor substrate 22 and the semiconductor substrate 52, specifically, in that the MOS transistor 12 and the inverter 13 are formed in the sensor-side wiring layer 23. The MOS transistor 12 and the inverter 13 are disposed at a position different from a position of the SPAD 11 including the P-type diffusion layer 32 and the N-type diffusion layer 33 in a thickness direction of the pixel substrate 21, and are disposed in a region in which at least a part of the MOS transistor 12 and the inverter 13 overlaps with the SPAD 11 in a plan view.

The contact electrode 41 as the cathode electrode connected to the contact layer 33A in the semiconductor substrate 22 is connected to a metal wiring 181 in the sensor-side wiring layer 23. The power supply voltage VE supplied from the logic substrate 51 is supplied to the contact electrode 41 via the MOS transistor 12 and the metal wiring 181.

The contact electrode 42 as the anode electrode is connected to the contact layer 34A in the semiconductor substrate 22, and the anode voltage VRLD is supplied from the logic substrate 51. On the other hand, illustration is omitted in Fig. 5 for the sake of space.

A metal wiring 121 formed on the bonding surface of the sensor-side wiring layer 23 is electrically and physically connected to a metal wiring 141 of the logic-side wiring layer 53 by metal bonding such as Cu-Cu. In addition, a metal wiring 122 is electrically and physically connected to a metal wiring 142 of the logic-side wiring layer 53 by metal bonding such as Cu-Cu.

Similarly to the SPAD pixel 10 of Fig. 3, the logic substrate 51 includes the semiconductor substrate 52 and the logic-side wiring layer 53. In the logic-side wiring layer 53, metal wirings 141 to 145 and contact electrodes 151 and 152 are formed in the interlayer insulating film 65.

The metal wiring 141 is electrically and physically connected to the metal wiring 121 of the sensor-side wiring layer 23 by metal bonding such as Cu-Cu. The contact electrode 151 connects the metal wiring 141 and the metal wiring 143. The metal wiring 142 is electrically and physically connected to the metal wiring 122 of the sensor-side wiring layer 23 by metal bonding such as Cu-Cu. The contact electrode 152 connects the metal wiring 142 and the metal wiring 144. The metal wirings 143 and 144 are formed in the same layer in the logic-side wiring layer 53, and the metal wiring 145 and the metal wiring 146 are formed in a layer different from the layer in which the metal wiring 143 and the metal wiring 144 are formed.

The logic-side wiring layer 53 includes at least twolayered metal wiring layers including a layer of the metal wirings 143 and 144 and a layer of the metal wiring 145 and an interlayer insulating film 65 between the layer of the metal wirings 143 and 144 and the layer of the metal wiring 145.

A plurality of MOS transistors Tr' is formed on the front surface side of the semiconductor substrate 52. The plurality of MOS transistors Tr' is a MOS transistor other than the MOS transistor 12 and the inverter 13 which are formed in the sensor-side wiring layer 23.

A metal bonding portion between the metal wiring 121 and the metal wiring 141 corresponds to, for example, the contact point C1 of Fig. 4, and a predetermined voltage supplied to a gate of the MOS transistor 12 formed in the sensor-side wiring layer 23 is supplied from the logic substrate 51 side to the pixel substrate 21 side.

A metal bonding portion between the metal wiring 122 and the metal wiring 142 corresponds to, for example, the contact point C2 of Fig. 4, and the power supply voltage VE supplied to the contact electrode 41 as the cathode electrode is supplied from the logic substrate 51 side to the pixel substrate 21 side.

A metal bonding portion corresponding to the contact point C3 of Fig. 4 is formed in a region not illustrated in Fig. 5.

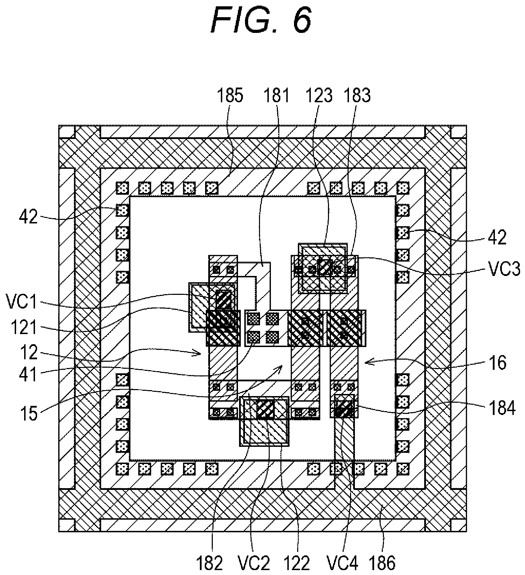

Fig. 6 is a plan view of the sensor-side wiring layer 23 of Fig. 5 when viewed from the semiconductor substrate 22 side.

In the sensor-side wiring layer 23, four contact electrodes 41 as cathode electrodes that supply the power supply voltage VE are disposed at a center portion of the rectangular pixel region. The four contact electrodes 41 are connected to a drain of the MOS transistor 12 via a metal wiring 181 of a first metal wiring layer M1. The gate of the MOS transistor 12 is connected to the metal wiring 121 as the contact point C1 that is formed on the bonding surface with the logic-side wiring layer 53 via a contact electrode VC1. The source of the MOS transistor 12 is connected to a contact electrode VC2 via a metal wiring 182 of the first metal wiring layer M1, and the contact electrode VC2 is connected to the metal wiring 122 as the contact point C2 that is formed on the bonding surface with the logic-side wiring layer 53.

A source of one MOS transistor 15 included in the inverter 13 is also connected to the contact electrode VC2 via the metal wiring 182 of the first metal wiring layer M1. A gate of the MOS transistor 15 is connected to the four contact electrodes 41 as cathode electrodes and a gate of the MOS transistor 16 by the metal wiring 181 of the first metal wiring layer M1. A drain of the MOS transistor 15 is connected to a contact electrode VC3 via a metal wiring 183 of the first metal wiring layer M1, and the contact electrode VC3 is connected to a metal wiring 123 as the contact point C3 that is formed on the bonding surface with the logic-side wiring layer 53.

A drain of the other MOS transistor 16 included in the inverter 13 is also connected to the contact electrode VC3 via the metal wiring 183 of the first metal wiring layer M1, and is connected to the metal wiring 123 as the contact point C3 via the contact electrode VC3. A gate of the MOS transistor 16 is connected to the gate of the MOS transistor 15 and the four contact electrodes 41 as cathode electrodes by the metal wiring 181 of the first metal wiring layer M1. A source of the MOS transistor 16 is connected to a contact electrode VC4 via a metal wiring 184 of the first metal wiring layer M1, and the contact electrode VC4 is connected to a GND wiring 186 of a second metal wiring layer M2. The GND wiring 186 of the second metal wiring layer M2 is disposed at an outer peripheral portion of the rectangular pixel region.

At the outer peripheral portion of the pixel region of the first metal wiring layer M1, a metal wiring 185 is formed so as to cover the GND wiring 186 of the second metal wiring layer M2. Further, a plurality of contact electrodes 42 connected to the contact layer 34A is disposed at a position overlapping with the metal wiring 185 inside the GND wiring 186, the contact electrode 42 being served as the anode electrode. The contact electrode 42 is only required to be connected to the contact layer 34A of the semiconductor substrate 22 at at least one point. On the other hand, in order to lower resistance, as illustrated in Fig. 6, the plurality of contact electrodes 42 is provided immediately below the contact layer 34A of the semiconductor substrate 22, and is connected to the contact layer 34A of the semiconductor substrate 22 at a plurality of points.

With the SPAD pixel 100 of the first embodiment described above, as described with reference to Fig. 4 to Fig. 6, the MOS transistor 12 and the inverter 13 (the MOS transistors 15 and 16) are formed in the sensor-side wiring layer 23 on the pixel substrate 21 side.

As compared with the SPAD pixel 10 of Fig. 1 and Fig. 3 described as the comparative example, the MOS transistors 12, 15, and 16, which are elements other than the SPAD 11, are disposed in the sensor-side wiring layer 23, and thus the number of elements disposed on the logic substrate 51 side can be reduced. Therefore, even in a case where the pixel size is reduced, necessary elements can be disposed in the pixel. That is, the pixel size can be reduced.

In a stack structure of the SPAD pixel 10 as the comparative example, as illustrated in Fig. 1, the contact point C0 between the pixel substrate 21 and the logic substrate 51 is on a connection wiring to which the cathode of the SPAD 11, the drain of the MOS transistor 12 as the constant current source, and the input terminal of the inverter 13 are connected. For this reason, the connection wiring connecting the cathode of the SPAD 11, the drain of the MOS transistor 12 as the constant current source, and the input terminal of the inverter 13 straddles the pixel substrate 21 and the logic substrate 51, and thus the connection wiring becomes long. As a result, cathode capacitance increases.

On the other hand, with the SPAD pixel 100 according to the first embodiment, all of the SPAD 11, the MOS transistor 12, and the inverter 13 are formed in the sensor-side wiring layer 23 on the pixel substrate 21 side. Thus, the connection wiring connecting the SPAD 11, the MOS transistor 12, and the inverter 13 can be shortened, and the cathode capacitance can be reduced.

### <3. Second Embodiment of SPAD Pixel>

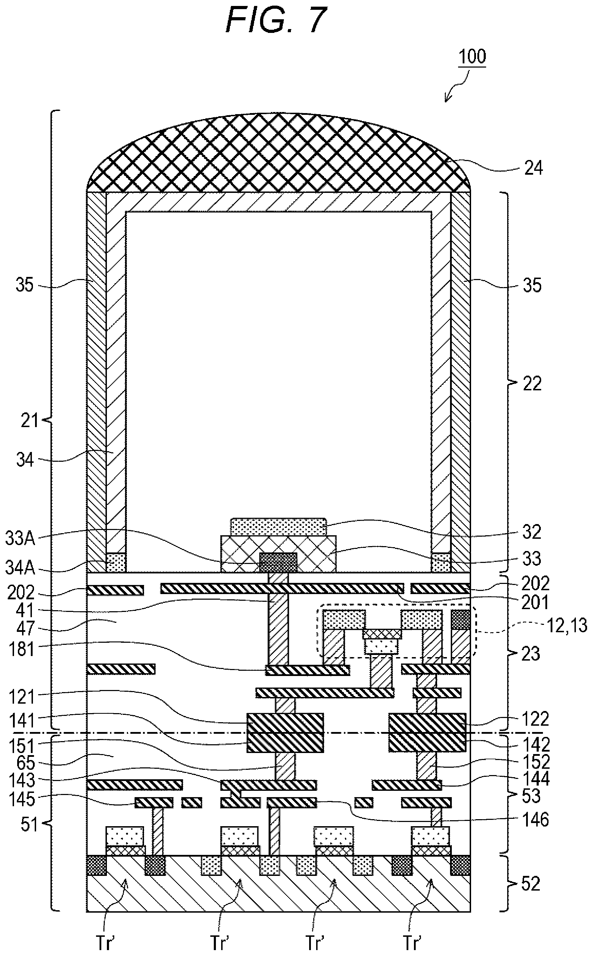

Fig. 7 is a cross-sectional view of an SPAD pixel according to a second embodiment of the present disclosure.

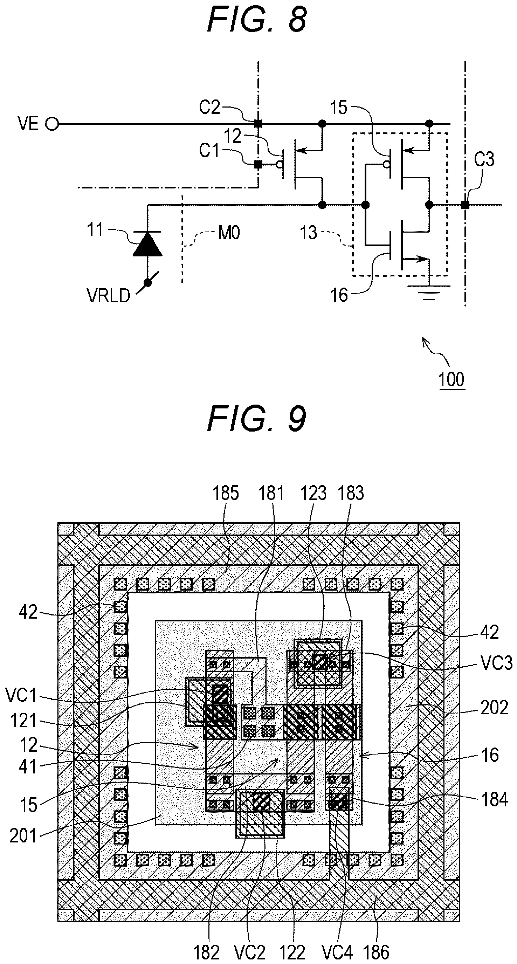

Fig. 8 illustrates a circuit example of the SPAD pixel according to the second embodiment.

In Fig. 7 and Fig. 8, portions corresponding to the SPAD pixel 10 of the comparative example described above or portions corresponding to the first embodiment are denoted by the same reference numerals, and a description thereof will be appropriately omitted. The same applies to third to tenth embodiments.

A difference between the cross-sectional view of the SPAD pixel 100 of Fig. 7 according to the second embodiment and the cross-sectional view of the SPAD pixel 100 according to the first embodiment illustrated in Fig. 5 is that a metal light shielding layer M0 is newly provided to be closer to the semiconductor substrate 22 side than the first metal wiring layer M1 in the sensor-side wiring layer 23. Specifically, in Fig. 7, metal wirings 201 and 202 are formed as the metal light shielding layer M0. The metal wiring 201 is formed in a planar region wider than the P-type diffusion layer 32 and the N-type diffusion layer 33 in which the avalanche multiplication region is formed, and the metal wiring 202 is formed at the outer peripheral portion of the pixel region in a planar region wider than the hole accumulation layer 34 including the contact layer 34A. The metal wirings 201 and 202 formed in the metal light shielding layer M0 are disposed between the semiconductor substrate 22 and the MOS transistor 12 and the inverter 13. Therefore, light passing through a photoelectric conversion region in the semiconductor substrate 22 is prevented from entering elements such as the MOS transistor 12 and the inverter 13 in a lower layer, and generation of photocurrent in the elements in the lower layer is prevented. In addition, by reflecting the light passing through the photoelectric conversion region in the semiconductor substrate 22 toward the semiconductor substrate 22 side, efficiency of the light contributing to the photoelectric conversion can be increased.

In the circuit of the SPAD pixel 100 according to the second embodiment illustrated in Fig. 8, a position of the metal light shielding layer M0 is indicated by a broken line.

Fig. 9 is a plan view of the sensor-side wiring layer 23 of Fig. 7 when viewed from the semiconductor substrate 22 side.

In Fig. 9, the metal wirings 201 and 202 of the metal light shielding layer M0 are illustrated by regions colored in gray. As illustrated in Fig. 9, the metal wiring 201 is disposed so as to cover and overlap with all of the four contact electrodes 41 in the center portion of the rectangular pixel region, the MOS transistor 12 as the constant current source, and the MOS transistors 15 and 16 included in the inverter 13. A plurality of metal wirings 202 is disposed as the anode electrodes, and is disposed at the outer peripheral portion of the pixel region so as to cover and overlap with all of the contact electrodes 42 connected to the contact layer 34A.

The SPAD pixel 100 according to the second embodiment is similar to the SPAD pixel 100 according to the first embodiment except that the metal wirings 201 and 202 are newly provided as the metal light shielding layer M0 in the sensor-side wiring layer 23.

With the SPAD pixel 100 of the second embodiment described above, similar to the first embodiment, elements (MOS transistors 12, 15, and 16) other than the SPAD 11 are formed in sensor-side wiring layer 23 on the pixel substrate 21 side. Therefore, the number of elements disposed on the logic substrate 51 side can be reduced, and thus the pixel size can be reduced. In addition, the connection wiring connecting the cathode of the SPAD 11, the drain of the MOS transistor 12 as the constant current source, and the input terminal of the inverter 13 can be shortened, and thus the cathode capacitance can be reduced.

Further, by providing the metal wirings 201 and 202 as the metal light shielding layer M0, it is possible to prevent light passing through a photoelectric conversion region in the semiconductor substrate 22 from entering elements such as the MOS transistor 12 and the inverter 13 in a lower layer, and to prevent generation of photocurrent in the elements in the lower layer.

### <4. Third Embodiment of SPAD Pixel>

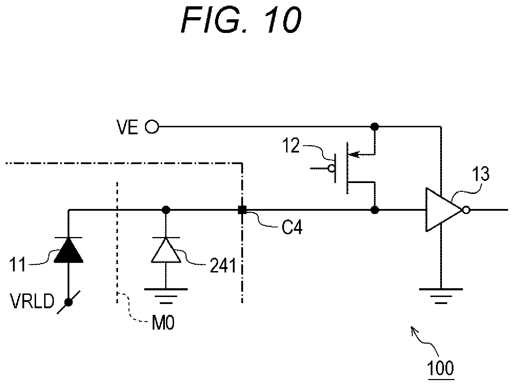

Fig. 10 illustrates a circuit example of an SPAD pixel according to a third embodiment of the present disclosure.

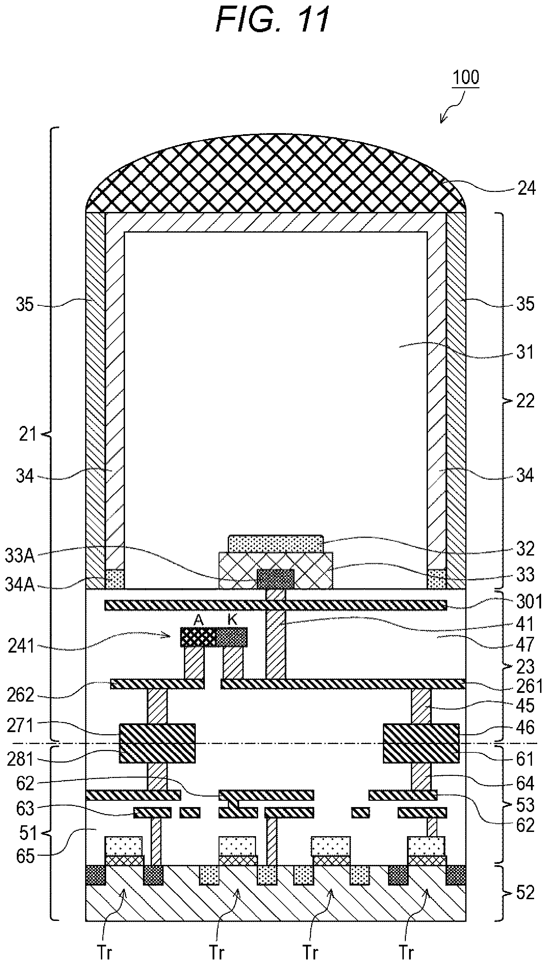

Fig. 11 is a cross-sectional view of the SPAD pixel according to the third embodiment.

In a case where the circuit of the SPAD pixel 100 according to the third embodiment illustrated in Fig. 10 is compared with the SPAD pixel 100 according to the first embodiment illustrated in Fig. 4, a diode 241 is further added. In addition, a metal light shielding layer M0 indicated by a broken line is disposed between the SPAD 11 and the diode 241.

An anode of the diode 241 is connected to GND. A cathode of the diode 241 is connected to the cathode of the SPAD 11, the drain of the MOS transistor 12, and the input terminal of the inverter 13.

In Fig. 10, a physical boundary (bonding surface) between the pixel substrate 21 and the logic substrate 51 is indicated by a one-dot chain line, and an electric contact point C4 between the pixel substrate 21 and the logic substrate 51 is disposed between the cathode of the diode 241 and the drain of the MOS transistor 12 and the input terminal of the inverter 13. The SPAD 11 and the diode 241 are formed on the pixel substrate 21 side, and the MOS transistor 12 and the inverter 13 are formed on the logic substrate 51 side.

In a case where the cathode side of the diode 241 becomes a negative voltage smaller than 0 V, a forward voltage is formed. Thus, a current flows through the diode 241, and the cathode side of the diode 241 becomes 0 V. That is, the diode 241 functions as a clamp circuit that prevents the voltage of the connection wiring connecting the cathode of the SPAD 11, the drain of the MOS transistor 12, and the input terminal of the inverter 13 from being lowered to a negative voltage smaller than 0 V. Therefore, it is possible to prevent a negative voltage from being applied to the MOS transistor 12 and the inverter 13, and to improve breakdown resistance in a case where a large amount of light is incident on the SPAD 11.

In addition, in the first and second embodiments, the power supply voltage VRLD supplied to the anode of the SPAD 11 is a negative bias having the same voltage as the breakdown voltage VBD of the SPAD 11. On the other hand, a negative bias lower than the breakdown voltage VBD (a voltage having a large absolute value of the breakdown voltage VBD) can be applied.

In the cross-sectional view of the SPAD pixel 100 according to the third embodiment illustrated in Fig. 11, the diode 241 is formed in the sensor-side wiring layer 23 on the pixel substrate 21 side. The diode 241 is disposed at a position different from a position of the SPAD 11 including the P-type diffusion layer 32 and the N-type diffusion layer 33 in a thickness direction of the pixel substrate 21, and is disposed in a region in which at least a part of the diode 241 overlaps with the SPAD 11 in a plan view. The cathode of the diode 241 is connected to the contact electrode 41 connected to the contact layer 33A via a metal wiring 261 formed in the first metal wiring layer M1 in the sensor-side wiring layer 23. The anode of the diode 241 is connected to a metal wiring 271 formed on the bonding surface of the sensor-side wiring layer 23 via a metal wiring 262 formed in the first metal wiring layer M1 in the sensor-side wiring layer 23. A metal wiring 271 is electrically and physically connected to a metal wiring 281 of the logic-side wiring layer 53 by metal bonding such as Cu-Cu, and is connected to GND on the logic substrate 51 side.

In addition, a metal wiring 301 is formed as the metal light shielding layer M0 to be closer to the semiconductor substrate 22 side than the first metal wiring layer M1 in the sensor-side wiring layer 23. The metal wiring 301 is disposed in the sensor-side wiring layer 23 between the SPAD 11 and the diode 241. The metal wiring 301 is formed in a planar region wider than the photoelectric conversion region in the semiconductor substrate 22. The metal wiring 301 formed in the metal light shielding layer M0 prevents light passing through the photoelectric conversion region in the semiconductor substrate 22 from entering the diode 241 and the like in a lower layer, and prevents generation of a photocurrent in the diode 241 and the like in the lower layer. In addition, by reflecting the light passing through the photoelectric conversion region in the semiconductor substrate 22 toward the semiconductor substrate 22 side, efficiency of the light contributing to the photoelectric conversion can be increased.

Other configurations of the SPAD pixel 100 according to the third embodiment are similar to the configurations of the SPAD pixel 10 of Fig. 3 described as the comparative example. The plurality of MOS transistors Tr formed on the logic substrate 51 side includes MOS transistors 12 and MOS transistors included in the inverter 13.

With the SPAD pixel 100 according to the third embodiment, by providing the diode 241 functioning as the clamp circuit, it is possible to prevent a negative voltage from being applied to the pixel substrate 21 side, and it is possible to improve breakdown resistance to a large amount of light. By disposing the diode 241, which is an element other than the SPAD 11, in the sensor-side wiring layer 23 on the pixel substrate 21 side, the number of elements to be disposed on the logic substrate 51 side can be reduced as compared with a case where all the elements are disposed on the logic substrate 51 side, and thus the pixel size can be reduced.

Note that, in the third embodiment described above, the metal wiring 301 of the metal light shielding layer M0 may be omitted.

### <5. Fourth Embodiment of SPAD Pixel>

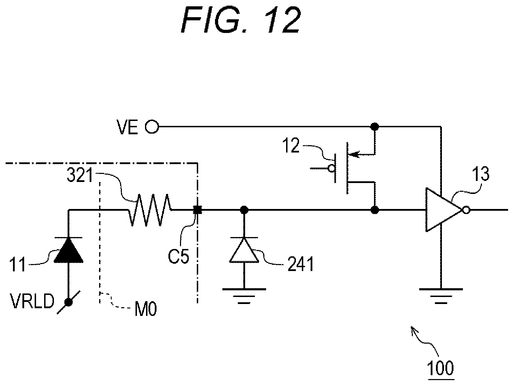

Fig. 12 illustrates a circuit example of an SPAD pixel according to a fourth embodiment of the present disclosure.

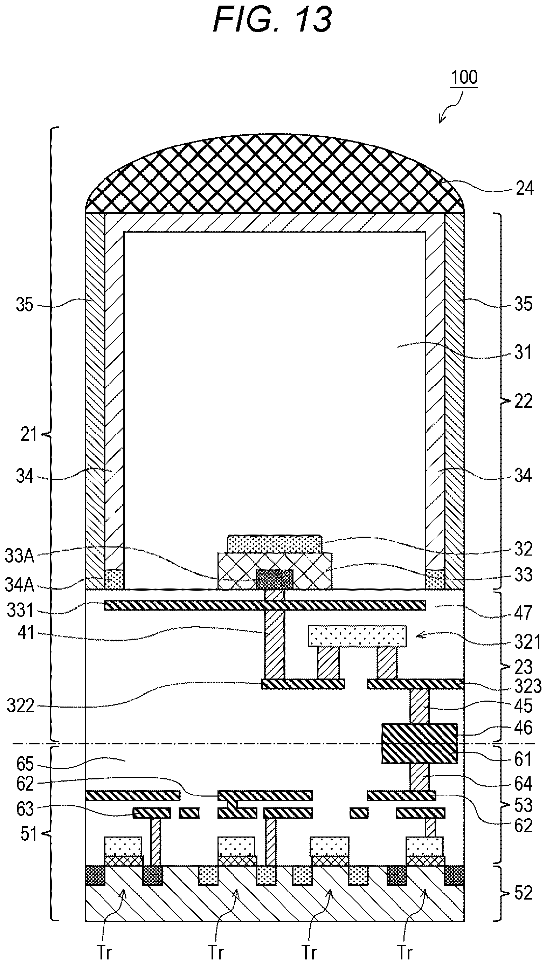

Fig. 13 is a cross-sectional view of the SPAD pixel according to the fourth embodiment.

In a case where the circuit of the SPAD pixel 100 according to the fourth embodiment illustrated in Fig. 12 is compared with the SPAD pixel 100 according to the third embodiment illustrated in Fig. 10, a resistor 321 is further added between the SPAD 11 and the cathode of the diode 241. A metal light shielding layer M0 indicated by a broken line is disposed between the SPAD 11 and the resistor 321.

In Fig. 12, a physical boundary (bonding surface) between the pixel substrate 21 and the logic substrate 51 is indicated by a one-dot chain line, and an electric contact point C5 between the pixel substrate 21 and the logic substrate 51 is disposed between the resistor 321 and the cathode of the diode 241. The SPAD 11 and the resistor 321 are formed on the pixel substrate 21 side, and the diode 241, the MOS transistor 12, and the inverter 13 are formed on the logic substrate 51 side.

The resistor 321 has a function of limiting a current flowing through the diode 241 as a clamp circuit. By providing the resistor 321, a size of the diode 241 can be reduced, and the circuit can be efficiently disposed.

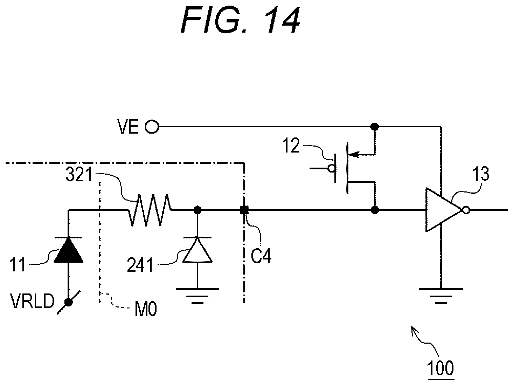

In the cross-sectional view of the SPAD pixel 100 illustrated in Fig. 13, the resistor 321 is formed in the sensor-side wiring layer 23 on the pixel substrate 21 side. The resistor 321 is disposed at a position different from a position of the SPAD 11 including the P-type diffusion layer 32 and the N-type diffusion layer 33 in a thickness direction of the pixel substrate 21, and is disposed in a region in which at least a part of the resistor 321 overlaps with the SPAD 11 in a plan view. One end of the resistor 321 is connected to the contact electrode 41 connected to the contact layer 33A via a metal wiring 322 formed in the first metal wiring layer M1 in the sensor-side wiring layer 23. The other end of the resistor 321 is connected to the metal wiring 46 formed on the bonding surface of the sensor-side wiring layer 23 via a metal wiring 323 formed in the first metal wiring layer M1 in the sensor-side wiring layer 23 and the contact electrode 45. The metal wiring 46 is electrically and physically connected to the metal wiring 61 of the logic-side wiring layer 53 by metal bonding such as Cu-Cu. A metal bonding portion between the metal wiring 46 and the metal wiring 61 corresponds to the contact point C5 in Fig. 14.

A metal wiring 331 is formed as the metal light shielding layer M0 to be closer to the semiconductor substrate 22 side than the first metal wiring layer M1 in the sensor-side wiring layer 23. The metal wiring 331 is disposed in the sensor-side wiring layer 23 between the SPAD 11 and the resistor 321. The metal wiring 331 is formed in a planar region wider than the photoelectric conversion region in the semiconductor substrate 22. The metal wiring 331 formed in the metal light shielding layer M0 prevents light passing through the photoelectric conversion region in the semiconductor substrate 22 from entering the resistor 321 and the like in a lower layer, and prevents generation of a photocurrent in the resistor 321 and the like in the lower layer. In addition, by reflecting the light passing through the photoelectric conversion region in the semiconductor substrate 22 toward the semiconductor substrate 22 side, efficiency of the light contributing to the photoelectric conversion can be increased.

With the SPAD pixel 100 according to the fourth embodiment, by providing the diode 241 functioning as the clamp circuit, it is possible to prevent a negative voltage from being applied to the pixel substrate 21 side, and it is possible to improve breakdown resistance to a large amount of light. Further, by providing the resistor 321 between the SPAD 11 and the cathode of the diode 241, the current flowing through the diode 241 can be suppressed, and the size of the diode 241 can be reduced.

In addition, by disposing the resistor 321, which is an element other than the SPAD 11, in the sensor-side wiring layer 23 on the pixel substrate 21 side, the number of elements to be disposed on the logic substrate 51 side can be reduced, and thus the pixel size can be reduced.

Note that, in the fourth embodiment described above, the metal wiring 331 of the metal light shielding layer M0 may be omitted.

### <6. Fifth Embodiment of SPAD Pixel>

Fig. 14 illustrates a circuit example of an SPAD pixel according to a fifth embodiment of the present disclosure.

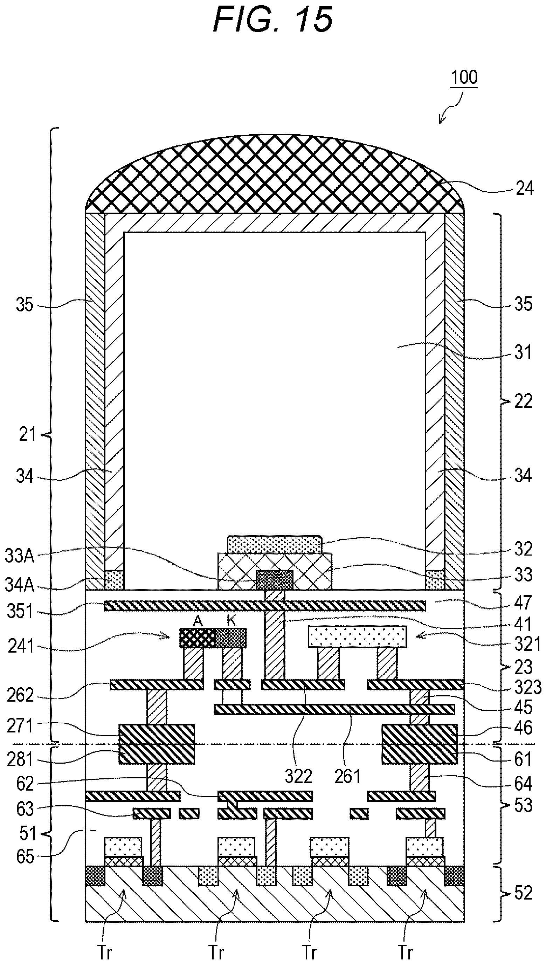

Fig. 15 is a cross-sectional view of the SPAD pixel according to the fifth embodiment.

The circuit of the SPAD pixel 100 according to the fifth embodiment illustrated in Fig. 14 is the same as the SPAD pixel 100 according to the fourth embodiment illustrated in Fig. 12. However, a physical boundary (bonding surface) which is between the pixel substrate 21 and the logic substrate 51 and is indicated by a one-dot chain line in Fig. 14 is different. In the fourth embodiment illustrated in Fig. 12, a boundary which is between the pixel substrate 21 and the logic substrate 51 and is indicated by a one-dot chain line is provided between the resistor 321 and the cathode of the diode 241. On the other hand, in the fifth embodiment of Fig. 14, the boundary is provided between the connection point between the resistor 321 and the cathode of the diode 241 and the connection point between the drain of the MOS transistor 12 and the input terminal of the inverter 13. In other words, the arrangement of the electric contact point C4 between the pixel substrate 21 and the logic substrate 51 is similar to the arrangement of the third embodiment illustrated in Fig. 10. The SPAD 11, the resistor 321, and the diode 241 are formed on the pixel substrate 21 side, and the MOS transistor 12 and the inverter 13 are formed on the logic substrate 51 side. A metal light shielding layer M0 indicated by a broken line is disposed between the SPAD 11 and the resistor 321 and the diode 241.

In the cross-sectional view of the SPAD pixel 100 illustrated in Fig. 15, the diode 241 and the resistor 321 are formed in the sensor-side wiring layer 23 on the pixel substrate 21 side. The diode 241 and the resistor 321 are disposed at a position different from a position of the SPAD 11 including the P-type diffusion layer 32 and the N-type diffusion layer 33 in a thickness direction of the pixel substrate 21, and are disposed in a region in which at least a part of the diode 241 and the resistor 321 overlaps with the SPAD 11 in a plan view.

The cathode of the diode 241 is connected to the metal wiring 46 formed on the bonding surface of the sensor-side wiring layer 23 via the metal wiring 261 and the like formed in the second metal wiring layer M2 in the sensor-side wiring layer 23. The anode of the diode 241 is connected to a metal wiring 271 formed on the bonding surface of the sensor-side wiring layer 23 via the metal wiring 262 formed in the first metal wiring layer M1 in the sensor-side wiring layer 23 and the like. A metal wiring 271 is electrically and physically connected to a metal wiring 281 of the logic-side wiring layer 53 by metal bonding such as Cu-Cu, and is connected to GND on the logic substrate 51 side.

One end of the resistor 321 is connected to the contact electrode 41 connected to the contact layer 33A via a metal wiring 322 formed in the first metal wiring layer M1 in the sensor-side wiring layer 23. The other end of the resistor 321 is connected to the metal wiring 46 formed on the bonding surface of the sensor-side wiring layer 23 via a metal wiring 323 formed in the first metal wiring layer M1 in the sensor-side wiring layer 23, the contact electrode 45, and the like. The metal wiring 46 is electrically and physically connected to the metal wiring 61 of the logic-side wiring layer 53 by metal bonding such as Cu-Cu. A metal bonding portion between the metal wiring 46 and the metal wiring 61 corresponds to the contact point C4 in Fig. 14.

In addition, a metal wiring 351 is formed as the metal light shielding layer M0 to be closer to the semiconductor substrate 22 side than the first metal wiring layer M1 in the sensor-side wiring layer 23. The metal wiring 351 is disposed in the sensor-side wiring layer 23 between the SPAD 11 and the resistor 321 and the diode 241. The metal wiring 351 is formed in a planar region wider than the photoelectric conversion region in the semiconductor substrate 22. The metal wiring 351 formed in the metal light shielding layer M0 prevents light passing through the photoelectric conversion region in the semiconductor substrate 22 from entering elements such as the diode 241, the resistor 321, and the like in a lower layer, and prevents generation of a photocurrent in the elements in the lower layer. In addition, by reflecting the light passing through the photoelectric conversion region in the semiconductor substrate 22 toward the semiconductor substrate 22 side, efficiency of the light contributing to the photoelectric conversion can be increased.

With the SPAD pixel 100 according to the fifth embodiment, by providing the diode 241 functioning as the clamp circuit, it is possible to prevent a negative voltage from being applied to the pixel substrate 21 side, and it is possible to improve breakdown resistance to a large amount of light. In addition, by providing the resistor 321 between the SPAD 11 and the cathode of the diode 241, the current flowing through the diode 241 can be suppressed, and the size of the diode 241 can be reduced. Further, by disposing the diode 241 and the resistor 321, which are elements other than the SPAD 11, in the sensor-side wiring layer 23 on the pixel substrate 21 side, the number of elements to be disposed on the logic substrate 51 side can be reduced, and thus the pixel size can be reduced.

Note that, in the fifth embodiment described above, the metal wiring 351 of the metal light shielding layer M0 may be omitted.

### <7. Sixth Embodiment of SPAD Pixel>

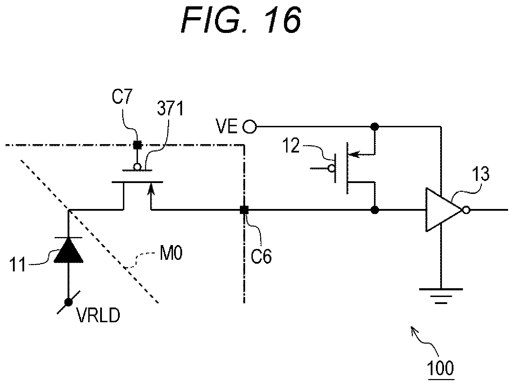

Fig. 16 illustrates a circuit example of an SPAD pixel according to a sixth embodiment of the present disclosure.

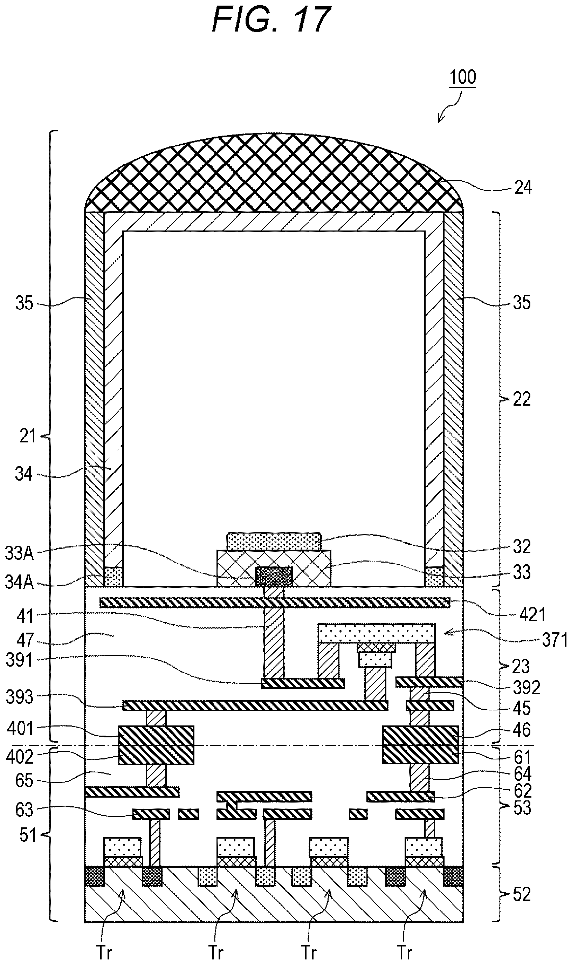

Fig. 17 is a cross-sectional view of the SPAD pixel according to the sixth embodiment.

In a case where the circuit of the SPAD pixel 100 according to the sixth embodiment illustrated in Fig. 16 is compared with the SPAD pixel 100 according to the first embodiment illustrated in Fig. 4, a P-type polysilicon thin film transistor 371 is further added. In addition, a metal light shielding layer M0 is disposed between the SPAD 11 and the polysilicon TFT 371.

The polysilicon TFT 371 is disposed between the cathode of the SPAD 11 and the drain of the MOS transistor 12 and the input terminal of the inverter 13. A source of the polysilicon TFT 371 is connected to the drain of the MOS transistor 12 and the input terminal of the inverter 13. A drain of the polysilicon TFT 371 is connected to the cathode of the SPAD 11. A predetermined voltage is applied to a gate of the polysilicon TFT 371.

In Fig. 16, a physical boundary (bonding surface) between the pixel substrate 21 and the logic substrate 51 is indicated by a one-dot chain line, and an electric contact point C6 between the pixel substrate 21 and the logic substrate 51 is disposed between the source of the polysilicon TFT 371 and the drain of the MOS transistor 12 and the input terminal of the inverter 13. An electric contact point C7 between the pixel substrate 21 and the logic substrate 51 is disposed between the gate of the polysilicon TFT 371 and a circuit (not illustrated) disposed ahead of the gate of the polysilicon TFT 371. The SPAD 11 and the polysilicon TFT 371 are formed on the pixel substrate 21 side, and the MOS transistor 12 and the inverter 13 are formed on the logic substrate 51 side.

By disposing the polysilicon TFT 371 between the SPAD 11 and the input terminal of the inverter 13, a potential difference can be provided between the SPAD 11 side and the inverter 13 side of the polysilicon TFT 371. The polysilicon TFT 371 functions as a clamp circuit. Thus, it is possible to limit a voltage drop of the input voltage of the inverter 13 in a case where a large amount of light is incident on the SPAD 11, and improve the breakdown resistance of the MOS transistor 12 and the inverter 13. In addition, by providing the polysilicon TFT 371 as a clamp circuit, it is possible to arbitrarily increase the power supply voltage VE corresponding to an excess bias within a range allowed by power consumption, and thus it is possible to improve photon detection efficiency (PDE) .

In the cross-sectional view of the SPAD pixel 100 illustrated in Fig. 17, the polysilicon TFT 371 is formed in the sensor-side wiring layer 23 on the pixel substrate 21 side. The polysilicon TFT 371 is disposed at a position different from a position of the SPAD 11 including the P-type diffusion layer 32 and the N-type diffusion layer 33 in a thickness direction of the pixel substrate 21, and is disposed in a region in which at least a part of the polysilicon TFT 371 overlaps with the SPAD 11 in a plan view.

The drain of the polysilicon TFT 371 is connected to the contact electrode 41 connected to the contact layer 33A via a metal wiring 391 formed in the first metal wiring layer M1 in the sensor-side wiring layer 23. The source of the polysilicon TFT 371 is connected to the metal wiring 46 formed on the bonding surface of the sensor-side wiring layer 23 via a metal wiring 392 formed in the first metal wiring layer M1, the contact electrode 45, and the like. The metal wiring 46 is electrically and physically connected to the metal wiring 61 of the logic-side wiring layer 53 by metal bonding such as Cu-Cu. A metal bonding portion between the metal wiring 46 and the metal wiring 61 corresponds to the contact point C6 in Fig. 16. The gate of the polysilicon TFT 371 is connected to the metal wiring 401 formed on the bonding surface of the sensor-side wiring layer 23 via a metal wiring 393 formed in the second metal wiring layer M2 in the sensor-side wiring layer 23. A metal wiring 401 is electrically and physically connected to a metal wiring 402 of the logic-side wiring layer 53 by metal bonding such as Cu-Cu, and is connected to a predetermined power supply circuit on the logic substrate 51 side. A metal bonding portion between the metal wiring 401 and the metal wiring 402 corresponds to the contact point C7 in Fig. 16.

In addition, a metal wiring 421 is formed as the metal light shielding layer M0 to be closer to the semiconductor substrate 22 side than the first metal wiring layer M1 in the sensor-side wiring layer 23. The metal wiring 421 is disposed in the sensor-side wiring layer 23 between the SPAD 11 and the polysilicon TFT 371. The metal wiring 421 is formed in a planar region wider than the photoelectric conversion region in the semiconductor substrate 22. The metal wiring 421 formed in the metal light shielding layer M0 prevents light passing through the photoelectric conversion region in the semiconductor substrate 22 from entering elements such as the polysilicon TFT 371 in a lower layer, and prevents generation of a photocurrent in the elements such as the polysilicon TFT 371 in the lower layer. In addition, by reflecting the light passing through the photoelectric conversion region in the semiconductor substrate 22 toward the semiconductor substrate 22 side, efficiency of the light contributing to the photoelectric conversion can be increased.

With the SPAD pixel 100 according to the sixth embodiment, by providing the polysilicon TFT 371 functioning as the clamp circuit, it is possible to prevent a voltage drop on the pixel substrate 21 side, and it is possible to improve breakdown resistance to a large amount of light. In addition, by providing the polysilicon TFT 371, it is possible to arbitrarily increase the power supply voltage VE corresponding to an excess bias, and thus it is possible to improve the PDE. Further, by disposing the polysilicon TFT 371, which is an element other than the SPAD 11, in the sensor-side wiring layer 23 on the pixel substrate 21 side, the number of elements to be disposed on the logic substrate 51 side can be reduced, and thus the pixel size can be reduced.

Note that, in the sixth embodiment described above, the metal wiring 421 of the metal light shielding layer M0 may be omitted.

### <8. Seventh Embodiment of SPAD Pixel>

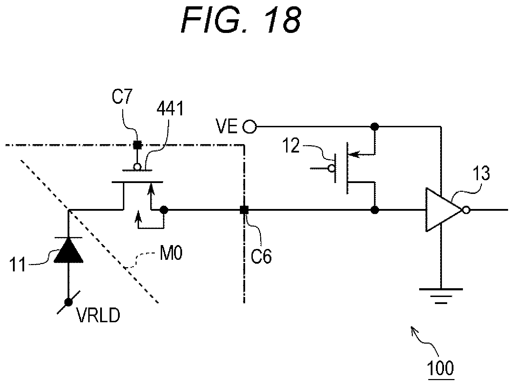

Fig. 18 illustrates a circuit example of an SPAD pixel according to a seventh embodiment of the present disclosure.

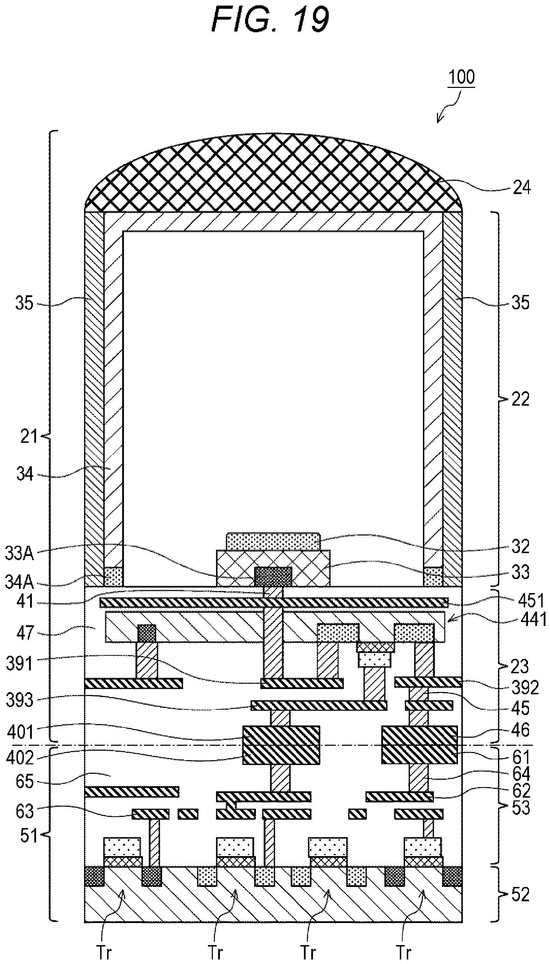

Fig. 19 is a cross-sectional view of the SPAD pixel according to the seventh embodiment.

In a case where the circuit of the SPAD pixel 100 according to the seventh embodiment illustrated in Fig. 18 is compared with the SPAD pixel 100 according to the sixth embodiment illustrated in Fig. 16, the P-type polysilicon TFT 371 is replaced with a P-type MOS transistor 441. That is, Fig. 16 and Fig. 18 illustrate a difference in whether a field effect transistor (FET) includes a TFT or a MOS transistor. The N-well in which the MOS transistor 441 is formed is connected to a source of the MOS transistor 441. The metal light shielding layer M0 is disposed between the SPAD 11 and the P-type MOS transistor 441.

In Fig. 18, a physical boundary (bonding surface) between the pixel substrate 21 and the logic substrate 51 is indicated by a one-dot chain line, and an electric contact point C6 between the pixel substrate 21 and the logic substrate 51 is disposed between the source of the MOS transistor 441 and the drain of the MOS transistor 12 and the input terminal of the inverter 13. An electric contact point C7 between the pixel substrate 21 and the logic substrate 51 is disposed between the gate of the MOS transistor 441 and a circuit (not illustrated) disposed ahead of the gate of the MOS transistor 441. The SPAD 11 and the MOS transistor 441 are formed on the pixel substrate 21 side, and the MOS transistor 12 and the inverter 13 are formed on the logic substrate 51 side.

One of differences between the cross-sectional view of the SPAD pixel 100 according to the seventh embodiment illustrated in Fig. 19 and the cross-sectional view of the SPAD pixel 1000 according to the sixth embodiment illustrated in Fig. 17 is that the MOS transistor 441 is provided in the sensor-side wiring layer 23 instead of the polysilicon TFT 371. The MOS transistor 441 is disposed at a position different from a position of the SPAD 11 including the P-type diffusion layer 32 and the N-type diffusion layer 33 in a thickness direction of the pixel substrate 21, and is disposed in a region in which at least a part of the MOS transistor 441 overlaps with the SPAD 11 in a plan view.

An operation and action in a case where the MOS transistor 441 is provided instead of the polysilicon TFT 371 are similar to the operation and action in the sixth embodiment in which the polysilicon TFT 371 is provided.

In addition, a metal wiring 451 is formed as the metal light shielding layer M0 to be closer to the semiconductor substrate 22 side than the first metal wiring layer M1. The metal wiring 451 is disposed in the sensor-side wiring layer 23 between the SPAD 11 and the MOS transistor 441. The metal wiring 451 is formed in a planar region wider than the photoelectric conversion region in the semiconductor substrate 22. The metal wiring 451 formed in the metal light shielding layer M0 prevents light passing through the photoelectric conversion region in the semiconductor substrate 22 from entering elements such as the MOS transistor 441 in a lower layer, and prevents generation of a photocurrent in the elements such as the MOS transistor 441 in the lower layer. In addition, by reflecting the light passing through the photoelectric conversion region in the semiconductor substrate 22 toward the semiconductor substrate 22 side, efficiency of the light contributing to the photoelectric conversion can be increased.

With the SPAD pixel 100 according to the seventh embodiment, by providing the MOS transistor 441 functioning as the clamp circuit, it is possible to prevent a voltage drop on the pixel substrate 21 side, and it is possible to improve breakdown resistance to a large amount of light. In addition, by providing the MOS transistor 441, it is possible to arbitrarily increase the power supply voltage VE corresponding to an excess bias, and thus it is possible to improve the PDE. Further, by disposing the MOS transistor 441, which is an element other than the SPAD 11, in the sensor-side wiring layer 23 on the pixel substrate 21 side, the number of elements to be disposed on the logic substrate 51 side can be reduced, and thus the pixel size can be reduced.

Note that, in the seventh embodiment described above, the metal wiring 451 of the metal light shielding layer M0 may be omitted.

### <9. Eighth Embodiment of SPAD Pixel>

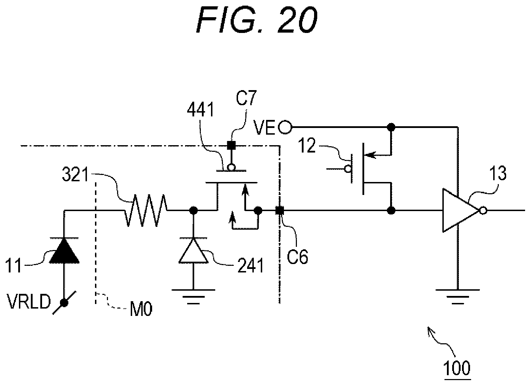

Fig. 20 illustrates a circuit example of an SPAD pixel according to an eighth embodiment of the present disclosure.

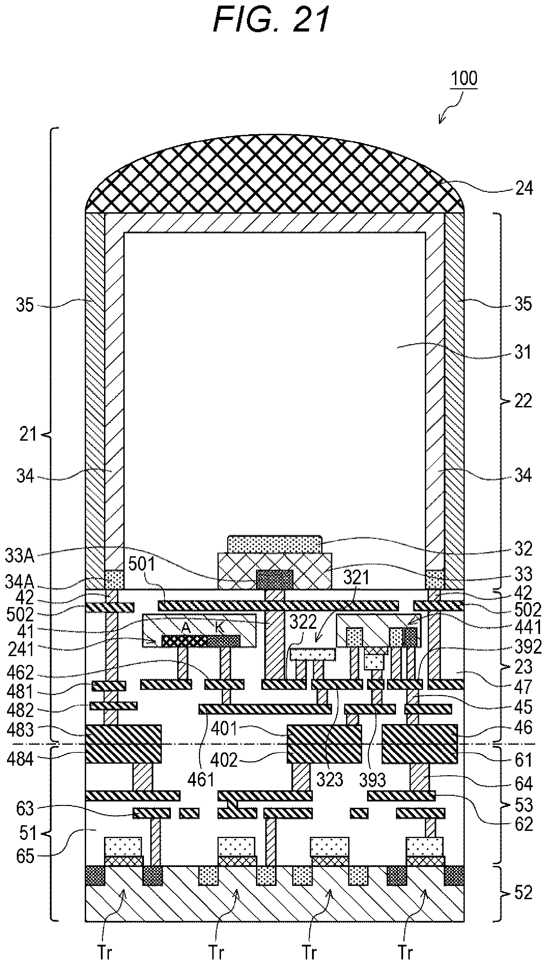

Fig. 21 is a cross-sectional view of the SPAD pixel according to the eighth embodiment.

The circuit of the SPAD pixel 100 according to the eighth embodiment illustrated in Fig. 20 includes the diode 241 of the third embodiment illustrated in Fig. 10, the resistor 321 of the fourth embodiment illustrated in Fig. 12, and the MOS transistor 441 of the seventh embodiment illustrated in Fig. 18. Therefore, effects by each of the diode 241, the resistor 321, and the MOS transistor 441 can be obtained. That is, by providing the diode 241 and the MOS transistor 441 as a clamp circuit, it is possible to prevent a negative voltage from being applied to the MOS transistor 12 and the inverter 13, and to improve breakdown resistance in a case where a large amount of light is incident on the SPAD 11. By providing the resistor 321, it is possible to limit the current flowing through the diode 241, and efficiently dispose the circuit by reducing the size of the diode 241. By providing the MOS transistor 441, it is possible to arbitrarily increase the power supply voltage VE corresponding to an excess bias, and thus it is possible to improve the PDE. Each of the diode 241, the resistor 321, and the MOS transistor 441 is a current limiting circuit that limits a current.

In Fig. 20, a physical boundary (bonding surface) between the pixel substrate 21 and the logic substrate 51 is indicated by a one-dot chain line, and is similar to the physical boundary of the seventh embodiment illustrated in Fig. 18. The SPAD 11, the diode 241, the resistor 321, and the MOS transistor 441 are formed on the pixel substrate 21 side, and the MOS transistor 12 and the inverter 13 are formed on the logic substrate 51 side.

In addition, a metal light shielding layer M0 indicated by a broken line is disposed between the SPAD 11 and the diode 241, the resistor 321, and the MOS transistor 441.

In the cross-sectional view of the SPAD pixel 100 according to the thirteen embodiment illustrated in Fig. 21, the diode 241, the resistor 321, and the MOS transistor 441 are disposed in the sensor-side wiring layer 23 on the pixel substrate 21 side. The diode 241, the resistor 321, and the MOS transistor 441 are disposed at a position different from a position of the SPAD 11 including the P-type diffusion layer 32 and the N-type diffusion layer 33 in a thickness direction of the pixel substrate 21, and are disposed in a region in which at least a part of the diode 241, the resistor 321, and the MOS transistor 441 overlaps with the SPAD 11 in a plan view.

Specifically, one end of the resistor 321 is connected to the contact electrode 41 connected to the contact layer 33A via a metal wiring 322 formed in the first metal wiring layer M1 in the sensor-side wiring layer 23. The other end of the resistor 321 is connected to the drain of the MOS transistor 441 via a metal wiring 323 formed in the first metal wiring layer M1 in the sensor-side wiring layer 23. In addition, the other end of the resistor 321 is also connected to the cathode of the diode 241 via the metal wirings 323, 461, and 462. The metal wiring 461 is formed in the second metal wiring layer M2, and the metal wiring 462 is formed in the first metal wiring layer M1.

The source of the MOS transistor 441 is connected to the metal wiring 46 formed on the bonding surface of the sensor-side wiring layer 23 via a metal wiring 392 formed in the first metal wiring layer M1, the contact electrode 45, and the like. The metal wiring 46 is electrically and physically connected to the metal wiring 61 of the logic-side wiring layer 53 by metal bonding such as Cu-Cu. A metal bonding portion between the metal wiring 46 and the metal wiring 61 corresponds to the contact point C6 in Fig. 20.

The gate of the MOS transistor 441 is connected to the metal wiring 401 formed on the bonding surface of the sensor-side wiring layer 23 via a metal wiring 393 formed in the second metal wiring layer M2 in the sensor-side wiring layer 23. A metal wiring 401 is electrically and physically connected to a metal wiring 402 of the logic-side wiring layer 53 by metal bonding such as Cu-Cu, and is connected to a predetermined power supply circuit on the logic substrate 51 side. A metal bonding portion between the metal wiring 401 and the metal wiring 402 corresponds to the contact point C7 in Fig. 20.

In addition, in Fig. 21, the contact electrode 42 is connected to the metal wiring 483 formed on the bonding surface of the sensor-side wiring layer 23 via the metal wirings 481 and 482 of the first metal wiring layer M1 and the second metal wiring layer M2, the contact electrode 42 being connected to the contact layer 34A formed on the outer peripheral portion of the pixel region of the semiconductor substrate 22. The metal wiring 483 is electrically and physically connected to the metal wiring 484 of the logic-side wiring layer 53 by metal bonding such as Cu-Cu. The anode voltage VRLD is supplied from a predetermined power supply circuit (not illustrated) of the logic-side wiring layer 53 to the contact layer 34A via the metal wirings 484 and 483, the contact electrode 42, and the like.

Metal wirings 501 and 502 are formed as the metal light shielding layer M0 to be closer to the semiconductor substrate 22 side than the first metal wiring layer M1 in the sensor-side wiring layer 23.

The metal wiring 501 is formed in a planar region wider than the avalanche multiplication region in the semiconductor substrate 22. The metal wiring layer 502 is formed on the outer peripheral portion of the pixel region in a planar region wider than the hole accumulation layer 34 including the contact layer 34A. The metal wirings 501 and 502 formed in the metal light shielding layer M0 are formed between the semiconductor substrate 22 and the diode 241, the resistor 321, and the MOS transistor 441. Therefore, light passing through the photoelectric conversion region in the semiconductor substrate 22 is prevented from entering the diode 241, the resistor 321, the MOS transistor 441, and the like in a lower layer, and photocurrent is prevented from being generated in the diode 241, the resistor 321, the MOS transistor 441, and the like in the lower layer by the metal light shielding layer M0. In addition, by reflecting the light passing through the photoelectric conversion region in the semiconductor substrate 22 toward the semiconductor substrate 22 side, efficiency of the light contributing to the photoelectric conversion can be increased.

With the SPAD pixel 100 according to the eighth embodiment, by providing the diode 241 and the MOS transistor 441 functioning as the clamp circuit, it is possible to prevent a negative voltage from being applied to the pixel substrate 21 side, and it is possible to improve breakdown resistance to a large amount of light. In addition, by providing the resistor 321, it is possible to suppress the current flowing through the diode 241, and reduce the size of the diode 241.

Further, by disposing the diode 241, the resistor 321, and the MOS transistor 441, which are elements other than the SPAD 11, in the sensor-side wiring layer 23 on the pixel substrate 21 side, the number of elements to be disposed on the logic substrate 51 side can be reduced, and thus the pixel size can be reduced.

Note that, in the eighth embodiment described above, the metal wirings 501 and 502 of the metal light shielding layer M0 may be omitted.

### <10. Ninth Embodiment of SPAD Pixel>

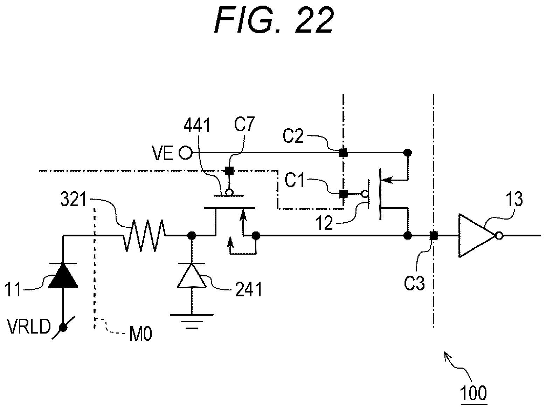

Fig. 22 illustrates a circuit example of an SPAD pixel according to a ninth embodiment of the present disclosure.

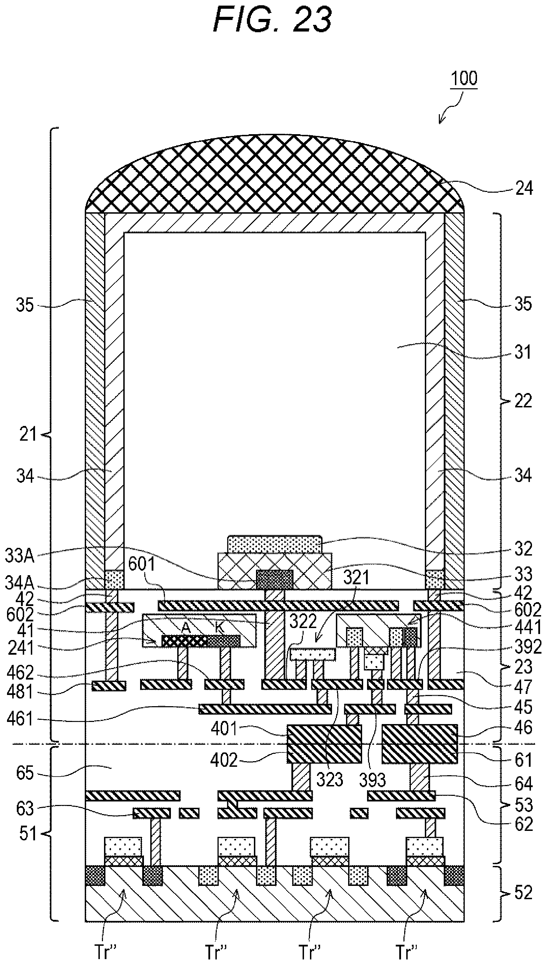

Fig. 23 is a cross-sectional view of the SPAD pixel according to the ninth embodiment.

The circuit of the SPAD pixel 100 according to the ninth embodiment illustrated in Fig. 22 is the same as the SPAD pixel 100 according to the eighth embodiment illustrated in Fig. 20. However, a physical boundary (bonding surface) which is between the pixel substrate 21 and the logic substrate 51 and is indicated by a one-dot chain line in Fig. 22 is different. That is, while, in the eighth embodiment illustrated in Fig. 20, the SPAD 11, the diode 241, the resistor 321, and the MOS transistor 441 are formed on the pixel substrate 21 side, in the ninth embodiment of Fig. 22, the MOS transistor 12 as the constant current source is also formed on the pixel substrate 21 side. The pixel substrate 21 and the logic substrate 51 are electrically connected to each other at four contact points of contact points C1 to C3 and C7. The contact point C1 is a gate portion of the MOS transistor 12, the contact point C2 is a supply portion of the power supply voltage VE, and the contact point C3 is an input portion of the inverter 13. The contact point C7 is disposed between the gate of the MOS transistor 441 and a circuit (not illustrated) disposed ahead of the gate of the MOS transistor 441.

The metal light shielding layer M0 indicated by a broken line is disposed between the SPAD 11 and the diode 241, the resistor 321, and the MOS transistor 441.

The cross-sectional view of the SPAD pixel 100 illustrated in Fig. 23 is illustrated similarly to the cross-sectional view of the eighth embodiment illustrated in Fig. 21. Here, although not illustrated for the sake of space, the MOS transistor 12 is formed in a predetermined region in the sensor-side wiring layer 23 of the pixel substrate 21. Therefore, a plurality of MOS transistors Tr" formed on the front surface side of the semiconductor substrate 52 does not include the MOS transistor 12, and includes the MOS transistors 15 and 16 included in the inverter 13. The MOS transistor 12, the diode 241, the resistor 321, and the MOS transistor 441 are disposed at a position different from a position of the SPAD 11 including the P-type diffusion layer 32 and the N-type diffusion layer 33 in a thickness direction of the pixel substrate 21, and are disposed in a region in which at least a part of the MOS transistor 12, the diode 241, the resistor 321, and the MOS transistor 441 overlaps with the SPAD 11 in a plan view.

Metal wirings 601 and 602 are formed as the metal light shielding layer M0 to be closer to the semiconductor substrate 22 side than the first metal wiring layer M1 in the sensor-side wiring layer 23.

The metal wiring 601 is formed in a planar region wider than the avalanche multiplication region in the semiconductor substrate 22. The metal wiring 602 is formed on the outer peripheral portion of the pixel region in a planar region wider than the hole accumulation layer 34 including the contact layer 34A. The metal wirings 601 and 602 formed in the metal light shielding layer M0 prevent light passing through the photoelectric conversion region in the semiconductor substrate 22 from entering the diode 241, the resistor 321, the MOS transistor 441, and the like in a lower layer, and prevent photocurrent from being generated in the diode 241, the resistor 321, the MOS transistor 441, and the like in the lower layer. In addition, by reflecting the light passing through the photoelectric conversion region in the semiconductor substrate 22 toward the semiconductor substrate 22 side, efficiency of the light contributing to the photoelectric conversion can be increased.

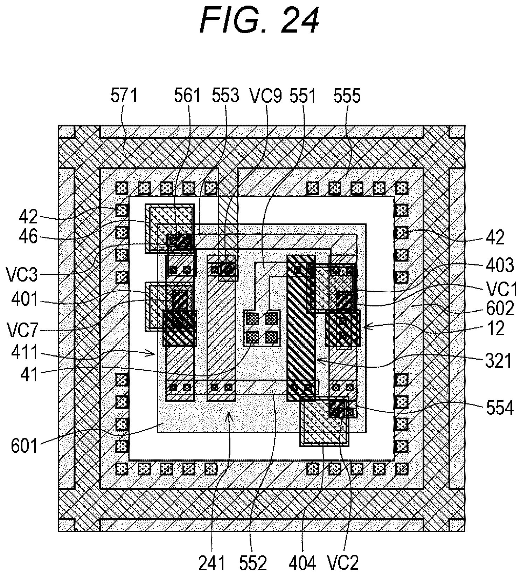

Fig. 24 is a plan view of the sensor-side wiring layer 23 of Fig. 23 when viewed from the semiconductor substrate 22 side. Note that, for convenience of description, wiring in the plan view of Fig. 24 does not match with wiring in the cross-sectional view of Fig. 23 in some portions.

In the sensor-side wiring layer 23, four contact electrodes 41 as cathode electrodes that supply the power supply voltage VE are disposed at a center portion of the rectangular pixel region. The four contact electrodes 41 are connected to one end of the resistor 321 via a metal wiring 551 of a first metal wiring layer M1. The other end of the resistor 321 is connected to a metal wiring 552 of the first metal wiring layer M1. The cathode of the diode 241 and the drain of the MOS transistor 441 are also connected to the metal wiring 552 of the first metal wiring layer M1.

The anode of the diode 241 is connected to a GND wiring 571 of a second metal wiring layer M2 via a contact electrode VC9.

The gate of the MOS transistor 441 is connected to the metal wiring 401 as the contact point C7 that is formed on the bonding surface with the logic-side wiring layer 53 via a contact electrode VC7. The source of the MOS transistor 441 is connected to a contact electrode VC3 via a metal wiring 553 of the first metal wiring layer M1, and the contact electrode VC3 is connected to the metal wiring 46 as the contact point C3 that is formed on the bonding surface with the logic-side wiring layer 53. The metal wiring 553 of the first metal wiring layer M1 is also connected to the N-well 561 of the MOS transistor 441 and the drain of the MOS transistor 12. The drain of the MOS transistor 12 is connected to the metal wiring 46 as the contact point C3 via the metal wiring 553.

The gate of the MOS transistor 12 is connected to the metal wiring 403 as the contact point C1 that is formed on the bonding surface with the logic-side wiring layer 53 via a contact electrode VC1. The source of the MOS transistor 12 is connected to the contact electrode VC2 via the metal wiring 554 of the first metal wiring layer M1. The contact electrode VC2 is connected to the metal wiring 404 as the contact point C2 that is formed on the bonding surface with the logic-side wiring layer 53.

A metal wiring 555 is formed in the first metal wiring layer M1 of the outer peripheral portion of the pixel region. The GND wiring 571 is disposed in the second metal wiring layer M2 of the outer peripheral portion of the rectangular pixel region. Further, a plurality of contact electrodes 42 connected to the contact layer 34A is disposed at a position overlapping with the metal wiring 555 inside the GND wiring 571. The contact electrode 42 as the anode electrode is only required to be connected to the contact layer 34A of the semiconductor substrate 22 at at least one point. On the other hand, in order to lower resistance, as illustrated in Fig. 24, the plurality of contact electrodes 42 is provided immediately below the contact layer 34A of the semiconductor substrate 22, and is connected to the contact layer 34A of the semiconductor substrate 22 at a plurality of points.

In Fig. 24, the metal wirings 601 and 602 of the metal light shielding layer M0 are illustrated by regions colored in gray. As illustrated in Fig. 24, the metal wiring 601 is disposed so as to cover and overlap with all of the four contact electrodes 41 in the center portion of the rectangular pixel region, the MOS transistor 12 as the constant current source, the diode 241, the resistor 321, and the MOS transistor 441. A plurality of metal wirings 602 is disposed as the anode electrodes, and is disposed at the outer peripheral portion of the pixel region so as to cover and overlap with all of the contact electrodes 42 connected to the contact layer 34A.

In planar arrangement of each element illustrated in Fig. 24, around the four contact electrodes 41 disposed in the center portion of the rectangular pixel region, the diode 241 and the resistor 321 are symmetrically disposed, and the MOS transistor 12 and the MOS transistor 441 are symmetrically disposed. Therefore, it is possible to improve incident angle dependence in a case where light enters the sensor-side wiring layer 23.

With the SPAD pixel 100 according to the ninth embodiment, by providing the diode 241 and the MOS transistor 441 functioning as the clamp circuit, it is possible to prevent a negative voltage from being applied to the pixel substrate 21 side, and it is possible to improve breakdown resistance to a large amount of light. By providing the resistor 321 between the SPAD 11 and the cathode of the diode 241, the current flowing through the diode 241 can be suppressed, and it is possible to efficiently dispose the circuit by reducing the size of the diode 241.

Further, by disposing the diode 241, the resistor 321, and the MOS transistors 12 and 441, which are elements other than the SPAD 11, in the sensor-side wiring layer 23 on the pixel substrate 21 side, the number of elements to be disposed on the logic substrate 51 side can be reduced, and thus the pixel size can be reduced.

Note that, in the ninth embodiment, the inverter 13 is disposed on the logic substrate 51 side. On the other hand, as in the first and second embodiments, the inverter 13 may also be disposed on the pixel substrate 21 side. Even in the ninth embodiment described above, the metal wirings 601 and 602 of the metal light shielding layer M0 may be omitted.

### <11. Tenth Embodiment of SPAD Pixel>

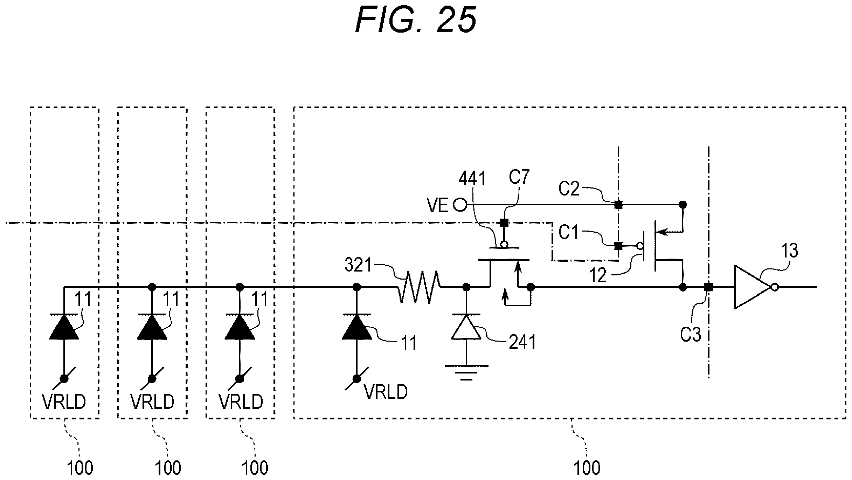

Fig. 25 illustrates a circuit example of an SPAD pixel according to a tenth embodiment of the present disclosure.

The tenth embodiment illustrated in Fig. 25 illustrates a configuration example of the SPAD pixel 100 in a case where the read circuit is shared by a plurality of SPAD pixels. Fig. 25 illustrates an example in which one read circuit is shared by four pixels.

Among the four SPAD pixels 100 illustrated in Fig. 25, only one SPAD pixel 100 is provided with a read circuit, and the other three SPAD pixels 100 are provided with only the SPAD 11. The read circuit is the same as the circuit of the ninth embodiment illustrated in Fig. 22, and includes a current limiting circuit of the diode 241, the resistor 321, and the MOS transistor 441, and the MOS transistor 12 and the inverter 13. A cathode of each of the four SPADs 11 sharing the read circuit is connected to one end of the resistor 321, and the diode 241 is connected to the other end of the resistor 321.

Note that, in Fig. 25, for convenience of description, one SPAD pixel 100 includes all elements of the shared read circuit. On the other hand, each element of the read circuit can be distributed and disposed in any of the shared four pixels. In other words, the diode 241, the resistor 321, the MOS transistor 441, the MOS transistor 12, and the inverter 13 may be disposed in any pixel of the four SPAD pixels 100 sharing the elements.

A physical boundary (bonding surface) between the pixel substrate 21 and the logic substrate 51 is similar to the physical boundary of the ninth embodiment illustrated in Fig. 22. The four SPADs 11, the MOS transistor 12, the diode 241, the resistor 321, and the MOS transistor 441 are disposed on the pixel substrate 21 side, and the inverter 13 is disposed on the logic substrate 51 side. In the tenth embodiment of Fig. 25, the metal light shielding layer M0 is not provided. On the other hand, similarly to the other embodiments described above, for example, the metal light shielding layer M0 may be disposed between the SPAD 11 and the resistor 321.

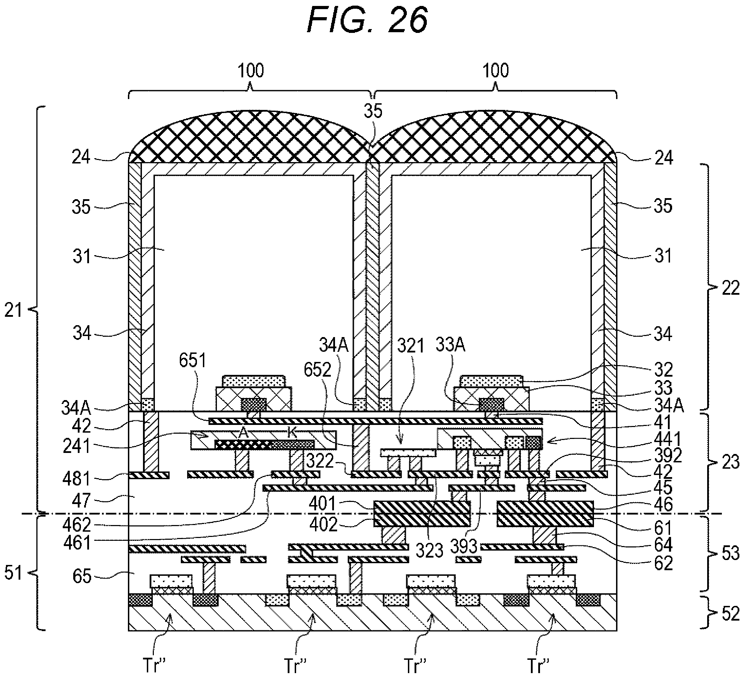

Fig. 26 is a cross-sectional view of the SPAD pixel according to the tenth embodiment.

Fig. 26 is a cross-sectional view of the SPAD pixels 100 of two pixels among four pixels sharing the read circuit. The diode 241, the resistor 321, the MOS transistor 441, and the MOS transistor 12 are formed in the sensor-side wiring layer 23 of the pixel substrate 21 of two adjacent pixels. Note that the MOS transistor 12 is formed in a region not illustrated in Fig. 26.

The contact electrode 41 is connected to the metal wiring 322 via the metal wiring 651 and the contact electrode 652 in the sensor-side wiring layer 23, the contact electrode 41 being a cathode electrode connected to the contact layer 33A in the semiconductor substrate 22 of each SPAD pixel 100. Other configurations are similar to the configurations of the ninth embodiment illustrated in Fig. 23, and thus a description thereof will be omitted. Here, the metal light shielding layer M0 is omitted.

With the SPAD pixel 100 according to the tenth embodiment, similarly to the ninth embodiment described above, by providing the diode 241 and the MOS transistor 441 functioning as the clamp circuit, it is possible to prevent a negative voltage from being applied to the pixel substrate 21 side, and it is possible to improve breakdown resistance to a large amount of light. By providing the resistor 321 between the SPAD 11 and the cathode of the diode 241, the current flowing through the diode 241 can be suppressed, and the size of the diode 241 can be reduced.

In addition, by disposing the diode 241, the resistor 321, and the MOS transistors 12 and 441, which are elements other than the SPAD 11, in the sensor-side wiring layer 23 on the pixel substrate 21 side, the number of elements to be disposed on the logic substrate 51 side can be reduced, and thus the pixel size can be reduced.

Further, by sharing the read circuit by the plurality of SPAD pixels 100, it is possible to have a margin in selecting a disposition place of each element included in the read circuit, and miniaturization of pixels is further facilitated and circuit design is facilitated. Other necessary circuits can also be disposed.

Note that the above-described example is an example in which one read circuit is shared by four pixels. On the other hand, the number of pixels sharing the read circuit is not limited to four. For example, two or three pixels may share one read circuit, or five or more pixels (for example, eight pixels) may share one read circuit.

In Fig. 25 and Fig. 26, an example in which the read circuit of the ninth embodiment illustrated in Fig. 22 is shared by a plurality of pixels has been described. However, it is needless to say that the configuration of the read circuit of each of the other embodiments described above can be shared by a plurality of pixels.

### <12. Detailed Configuration Example of Sensor-side Wiring Layer>

In the pixel structures of the first to tenth embodiments, as described above, at least one element such as the diode 241, the resistor 321, the MOS transistor 441, the MOS transistor 12, or the like is formed in the sensor-side wiring layer 23. Hereinafter, a detailed configuration example of the sensor-side wiring layer 23 in a case where each element is formed will be described.

### <Case where Element is not formed>

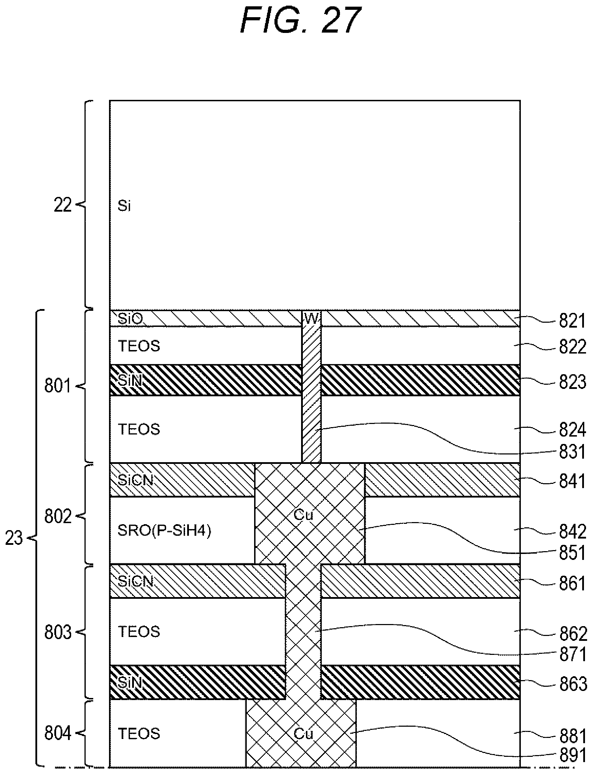

First, a detailed configuration of the sensor-side wiring layer 23 in a case where an element is not formed on the pixel substrate 21 side as in the sensor-side wiring layer 23 of the SPAD pixel 10 of Fig. 3 described as the comparative example will be described with reference to the cross-sectional view of Fig. 27.

In Fig. 27, an upper side of Fig. 27 is the semiconductor substrate 22 including the P-type diffusion layer 32 and the N-type diffusion layer 33 in which the avalanche multiplication region is formed, and a lower side of Fig. 27 is the bonding surface which is between the pixel substrate 21 and the logic substrate 51 and is indicated by a one-dot chain line. Here, in Fig. 27, detailed configurations of the P-type diffusion layer 32, the N-type diffusion layer 33, and the like in the semiconductor substrate 22 are omitted.

The sensor-side wiring layer 23 is formed by stacking a via formation layer 801, a first metal wiring layer 802, a via formation layer 803, and a bonding metal wiring layer 804 in this order from a side closer to the semiconductor substrate 22 toward the bonding surface with the logic substrate 51.

The via formation layer 801 includes an interlayer connection via 831 and a plurality of interlayer insulating films. In the example of Fig. 27, the plurality of interlayer insulating films is configured by stacking four layers of a SiO film 821, a TEOS film 822, a SiN film 823, and a TEOS film 824. The interlayer connection via 831 is formed using, for example, tungsten (W), and penetrates the via formation layer 801. The interlayer connection via 831 corresponds to, for example, the contact electrode 41 and the contact electrode 42 in Fig. 3.

The first metal wiring layer 802 includes a metal wiring 851 and a plurality of interlayer insulating films. In the example of Fig. 27, the plurality of interlayer insulating films is configured by stacking two layers of a SiCN film 841 and an SRO (P-SiH4) film 842. The metal wiring 851 is formed using, for example, copper (Cu). The metal wiring 851 corresponds to, for example, the metal wiring 43 and the metal wiring 44 in Fig. 3.

The via formation layer 803 includes an interlayer connection via 871 and a plurality of interlayer insulating films. In the example of Fig. 27, the plurality of interlayer insulating films is configured by stacking three layers of a SiCN film 861, a TEOS film 862, and a SiN film 863. The interlayer connection via 871 is formed using, for example, copper (Cu). The interlayer connection via 871 corresponds to, for example, the contact electrode 45 of Fig. 3.

The bonding metal wiring layer 804 includes a metal wiring 891 and one or more interlayer insulating films. In the example of Fig. 27, the interlayer insulating film includes a single-layer TEOS film 881. The metal wiring 891 is formed using, for example, copper (Cu). The metal wiring 891 corresponds to, for example, the metal wiring 46 of Fig. 3.

### <Case where resistor is formed>

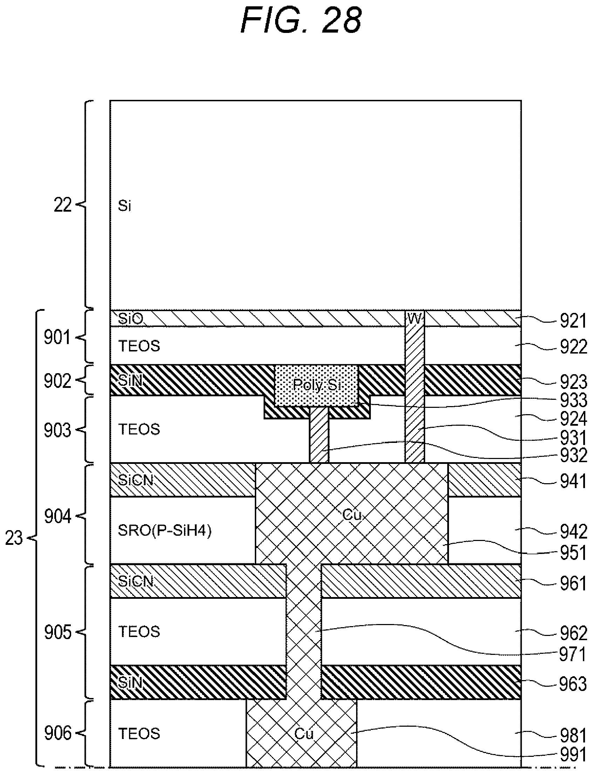

Fig. 28 is a cross-sectional view illustrating a detailed configuration example of the sensor-side wiring layer 23 in a case where the resistor 321 is formed on the pixel substrate 21 side, for example, as in the sensor-side wiring layer 23 of the SPAD pixel 10 according to the fourth embodiment illustrated in Fig. 12.

In Fig. 28 to Fig. 31, an upper side of Fig. 28 to Fig. 31 represents the semiconductor substrate 22, a lower side of Fig. 28 to Fig. 31 represents the bonding surface between the pixel substrate 21 and the logic substrate 51, and the detailed configuration in the semiconductor substrate 22 is omitted similarly to Fig. 27 described above.

The sensor-side wiring layer 23 is configured by stacking a via formation layer 901, a polysilicon layer 902, a via formation layer 903, a first metal wiring layer 904, a via formation layer 905, and a bonding metal wiring layer 906 in this order from a side closer to the semiconductor substrate 22 toward the bonding surface with the logic substrate 51.

The via formation layer 901 includes an interlayer connection via 931 and a plurality of interlayer insulating films. In the example of Fig. 28, the plurality of interlayer insulating films is configured by stacking two layers of a SiO film 921 and a TEOS film 922. The interlayer connection via 931 is formed using, for example, tungsten (W), and penetrates the via formation layer 901, the polysilicon layer 902, and the via formation layer 903. The interlayer connection via 931 corresponds to, for example, the contact electrode 41 and the contact electrode 42 in Fig. 21.

The polysilicon layer 902 includes an interlayer connection via 931, a resistor 933, and an interlayer insulating film. In the example of Fig. 28, the interlayer insulating film includes a SiN film 923. The resistor 933 includes, for example, a polysilicon film. The resistor 933 may include a metal film.

The via formation layer 903 includes interlayer connection vias 931 and 932 and one or more interlayer insulating films. In the example of Fig. 28, the interlayer insulating film includes a single-layer TEOS film 924. The interlayer connection via 932 is formed using, for example, tungsten (W), and connects the resistor 933 and the metal wiring 951.

The first metal wiring layer 904 includes a metal wiring 951 and a plurality of interlayer insulating films. In the example of Fig. 28, the plurality of interlayer insulating films is configured by stacking two layers of a SiCN film 941 and an SRO (P-SiH4) film 942. The metal wiring 951 is formed using, for example, copper (Cu). The metal wiring 951 corresponds to, for example, the metal wiring 322 and the metal wiring 323 in Fig. 13.

The via formation layer 905 includes an interlayer connection via 971 and a plurality of interlayer insulating films. In the example of Fig. 28, the plurality of interlayer insulating films is configured by stacking three layers of a SiCN film 961, a TEOS film 962, and a SiN film 963. The interlayer connection via 971 is formed using, for example, copper (Cu). The interlayer connection via 971 corresponds to, for example, the contact electrode 45 of Fig. 13.

The bonding metal wiring layer 906 includes a metal wiring 991 and one or more interlayer insulating films. In the example of Fig. 28, the interlayer insulating film includes a single-layer TEOS film 981. The metal wiring 991 is formed using, for example, copper (Cu). The metal wiring 991 corresponds to, for example, the metal wiring 46 of Fig. 13.

As described above, the resistor 933 can be formed in the sensor-side wiring layer 23 using a polysilicon film or a metal film.

### <Case where polysilicon TFT is formed>

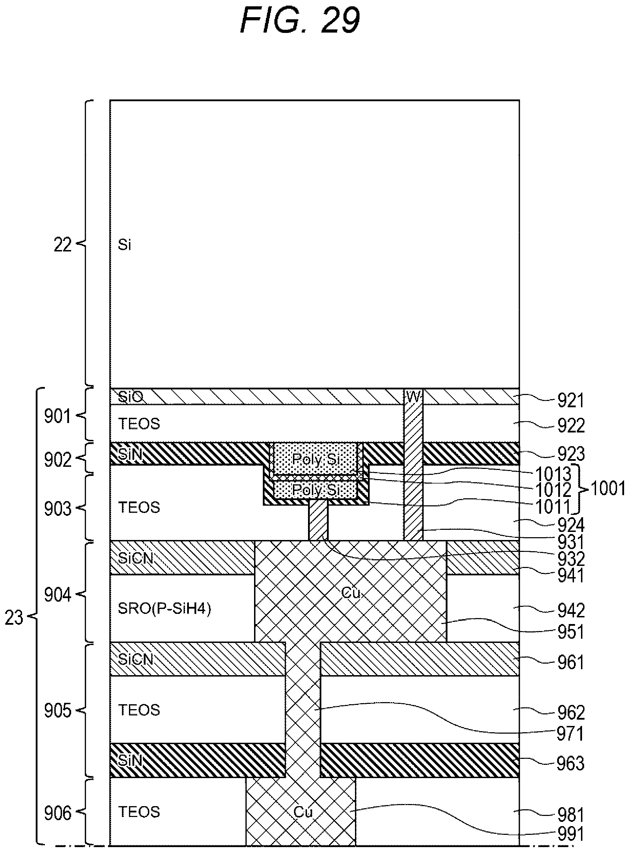

Fig. 29 is a cross-sectional view illustrating a detailed configuration example of the sensor-side wiring layer 23 in a case where the polysilicon TFT 371 is formed on the pixel substrate 21 side, for example, as in the sensor-side wiring layer 23 of the SPAD pixel 10 according to the sixth embodiment illustrated in Fig. 17.

In Fig. 29, the same reference numerals are given to portions common to Fig. 28, and a description of the portions will be appropriately omitted.

The sensor-side wiring layer 23 is configured by stacking a via formation layer 901, a polysilicon layer 902, a via formation layer 903, a first metal wiring layer 904, a via formation layer 905, and a bonding metal wiring layer 906 in this order from a side closer to the semiconductor substrate 22 toward the bonding surface with the logic substrate 51. The configuration of Fig. 29 is similar to the configuration of Fig. 28 except that a polysilicon TFT 1001 is formed in the polysilicon layer 902 instead of the resistor 933 of Fig. 28.

In the polysilicon layer 902, a polysilicon TFT 1001 is formed instead of the resistor 933 of Fig. 28. The polysilicon TFT 1001 includes a gate 1011, a gate insulating film 1012, and a drain/source 1013. The gate 1011 and the drain/source 1013 include a polysilicon film, and the gate insulating film 1012 includes SiO or SiN. The drain/source 1013 is one of a drain and a source, and the other of the drain and the source is formed in a region not illustrated in Fig. 29.

As described above, the polysilicon TFT 1001 can be formed in the sensor-side wiring layer 23 using a polysilicon film.

### <Case where MOS transistor is formed>

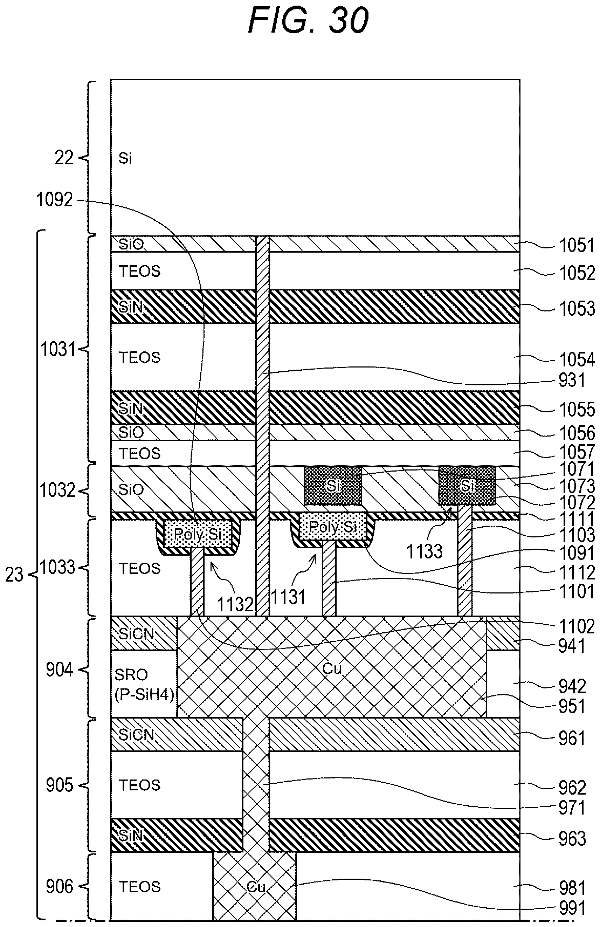

Fig. 30 is a cross-sectional view illustrating a detailed configuration example of the sensor-side wiring layer 23 in a case where the diode 241, the resistor 321, and the MOS transistor 441 are formed on the pixel substrate 21 side, for example, as in the sensor-side wiring layer 23 of the SPAD pixel 10 according to the eighth embodiment illustrated in Fig. 21.

In Fig. 30, the same reference numerals are given to portions common to Fig. 28 and Fig. 29, and a description of the portions will be appropriately omitted.

The sensor-side wiring layer 23 is configured by stacking a via formation layer 1031, a silicon layer 1032, a via formation layer 1033, a first metal wiring layer 904, a via formation layer 905, and a bonding metal wiring layer 906 in this order from a side closer to the semiconductor substrate 22 toward the bonding surface with the logic substrate 51. Therefore, in the sensor-side wiring layer 23 of Fig. 30, a configuration of the via formation layer 1031, the silicon layer 1032, and the via formation layer 1033 is different from the configuration of the sensor-side wiring layer 23 of Fig. 28 and Fig. 29, and a configuration of the first metal wiring layer 904, the via formation layer 905, and the bonding metal wiring layer 906 is similar to the configuration of Fig. 28 and Fig. 29.

The via formation layer 1031 includes an interlayer connection via 931 and a plurality of interlayer insulating films. In the example of Fig. 30, the plurality of interlayer insulating films is configured by stacking seven layers of a SiO film 1051, a TEOS film 1052, a SiN film 1053, a TEOS film 1054, a SiN film 1055, a SiO film 1056, and a TEOS film 1057. The interlayer connection via 931 is formed using, for example, tungsten (W), and penetrates the via formation layer 1031, the silicon layer 1032, and the via formation layer 1033. The interlayer connection via 931 corresponds to, for example, the contact electrode 41 and the contact electrode 42 in Fig. 21.

The silicon layer 1032 includes an interlayer connection via 931, silicon films 1071 and 1072, and an interlayer insulating film. In the example of Fig. 30, the interlayer insulating film includes a SiO film 1073.

The via formation layer 1033 includes an interlayer connection via 931, polysilicon films 1091 and 1092, interlayer connection vias 1101 to 1103, and an interlayer insulating film. In the example of Fig. 30, the interlayer insulating film includes a SiN film 1111 and a TEOS film 1112.

In the silicon layer 1032 and the via formation layer 1033, a MOS transistor 1131, a resistor 1132, and a diode 1133 are formed. The MOS transistor 1131, the resistor 1132, and the diode 1133 correspond to, for example, the MOS transistor 441, the resistor 321, and the diode 241 illustrated in Fig. 21. Here, in the example of Fig. 30, unlike the circuit of Fig. 21, for convenience of description, all of the MOS transistor 1131, the resistor 1132, and the diode 1133 are connected to the same metal wiring 951 by the interlayer connection vias 1101 to 1103.

In the MOS transistor 1131, a gate includes a polysilicon film 1091, a gate insulating film includes a SiO film 1073, and one of a source and a drain includes a silicon film 1071. The other of the source and the drain is formed in a region (not illustrated) on the same plane as a plane of the silicon film 1071.

The resistor 1132 includes a polysilicon film 1092. The diode 1133 includes a silicon film 1072. Note that the diode 1133 may include the polysilicon film 1092 as in the resistor 1132 and the resistor 1132 may include the silicon film 1072 as in the diode 1133.

The interlayer connection vias 1101 to 1103 are formed using, for example, tungsten (W), and penetrate the via formation layer 1033.

As described above, the MOS transistor 1131 can be formed in the sensor-side wiring layer 23 using the silicon layer 1032.

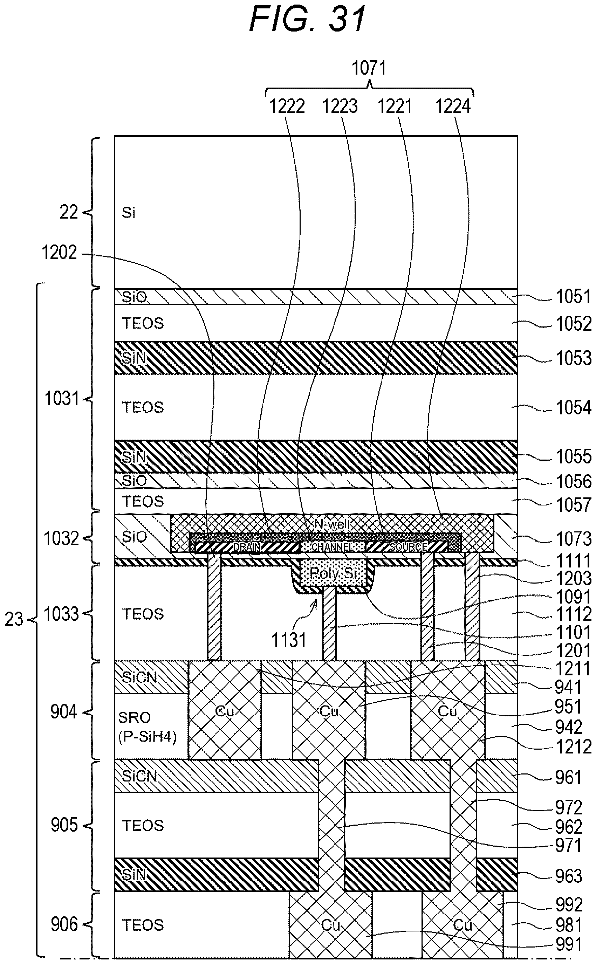

Fig. 31 is a cross-sectional view illustrating a detailed configuration example of the sensor-side wiring layer 23 from an angle at which both the source and the drain of the MOS transistor 1131 of Fig. 30 are visible.

A source 1221, a drain 1222, a channel 1223, and an N-well 1224 of the MOS transistor 1131 are formed in the silicon film 1071 of the silicon layer 1032. The source 1221 and the N-well 1224 of the MOS transistor 1131 are respectively connected to a wiring metal 1212 to which the power supply voltage VE is supplied by interlayer connection vias 1201 and 1203 of the via formation layer 1033. The wiring metal 1212 is connected to a supply circuit of the power supply voltage VE on the logic substrate 51 side via an interlayer connection via 972 and a metal wiring 992. The drain 1222 of the MOS transistor 1131 is connected to the wiring metal 1211 via an interlayer connection via 1202.

### <13. Summary of Embodiments of SPAD Pixel>

As described above, the SPAD pixel 100 according to the first to tenth embodiments is configured by stacking two substrates of the pixel substrate 21 (first substrate 21) and the logic substrate 51 (second substrate 51). Then, the SPAD 11 and at least one element included in the read circuit are disposed in the sensor-side wiring layer 23 which is the wiring layer 23 on the pixel substrate 21 side on which the SPAD 11 is formed. The read circuit includes a MOS transistor 12, an inverter 13 (MOS transistors 15 and 16), a diode 241, a resistor 321, a polysilicon TFT 371, and a MOS transistor 441. The diode 241, the resistor 321, the polysilicon TFT 371, and the MOS transistor 441 function as a current limiting circuit or a clamp circuit.

By forming the SPAD pixel 100 with a stack structure of two substrates, as compared with a case where one substrate is used, it is not necessary to form elements such as a MOS transistor and the like on the semiconductor substrate 22 which is on the pixel substrate 21 side. Thus, a large photoelectric conversion region can be secured, and high PDE can be realized. In addition, as compared with a stack structure of three substrates, only two substrates need to be stacked, and thus it is possible to improve process easiness and reduce a manufacturing cost.

Further, as in the comparative example illustrated in Fig. 1 and Fig. 3, as compared with a case where all the elements other than the SPAD 11 are disposed on the logic substrate 51 side, it is possible to reduce the number of elements disposed on the logic substrate 51. Thus, circuit arrangement in the logic substrate 51 can be facilitated, and the pixel size can be reduced.

In a case where the MOS transistor 12 and the inverter 13 are disposed on the pixel substrate 21 side, the cathode capacitance can be reduced, and thus it is possible to improve a time (dead time) until a state where the next new photon can be detected by a recharge operation.

By providing the clamp circuit on the SPAD pixel 100, it is possible to arbitrarily increase the power supply voltage VE corresponding to an excess bias within a range allowed by power consumption, and thus it is possible to improve the PDE. In addition, by providing the clamp circuit, it is possible to improve the breakdown resistance of the read circuit in a case where a large amount of light is incident on the SPAD 11.

By providing the metal wiring 201 and the like as the metal light shielding layer M0 in the sensor-side wiring layer 23, it is possible to prevent light passing through a photoelectric conversion region in the semiconductor substrate 22 from entering elements in a lower layer, and to prevent generation of photocurrent in the elements in the lower layer.

A configuration in which at least two embodiments of the first to tenth embodiments described above are arbitrarily combined can be used, and a configuration of any one embodiment of the first to tenth embodiments can be incorporated in or replaced with a configuration of another embodiment.

The configuration example of the SPAD pixel 100 described above is an example of a structure in which electrons are read as signal charges (carriers). On the other hand, a structure in which holes are read may be used. In this case, the N-type diffusion layer 33 is changed to a P-type diffusion layer, and the P-type diffusion layer 32 is changed to an N-type diffusion layer. In addition, the hole accumulation layer 34 is changed to an N-type diffusion layer. Further, the power supply voltage VRLD is applied to the contact layer 33A changed from the N-type diffusion layer 33 to a P-type diffusion layer, and the power supply voltage VE is applied to the contact layer 34A changed from the P-type diffusion layer 32 to an N-type diffusion layer.

### <14. Configuration Example of Ranging System>

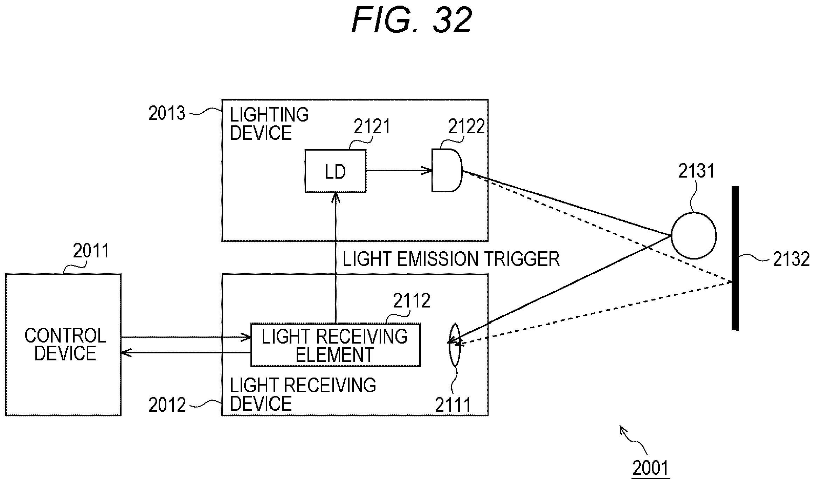

Fig. 32 is a block diagram illustrating a configuration example of a ranging system that includes a light receiving element including the above-described SPAD pixel 100 as a pixel array.

A ranging system 2001 of Fig. 32 includes a control device 2011, a light receiving device 2012, and a lighting device 2013.

The control device 2011 is a device that controls an operation of the entire ranging system 2001. In a case where a distance measurement instruction is received from a host device in a higher level, for example, the control device 2011 supplies a light emission request to the light receiving device 2012. Further, the control device 2011 obtains distance measurement data, which is a result of ranging performed by the light receiving device 2012 in response to the light emission request, from the light receiving device 2012.

The light receiving device 2012 causes the lighting device 2013 to emit irradiation light in response to the light emission request from the control device 2011, and receives reflected light obtained by the irradiation light being reflected by an object such as a subject 2131 and a subject 2132. Thus, a distance to the object is measured and output.

The light receiving device 2012 includes a lens 2111 and a light receiving element 2112. The lighting device 2013 includes an LD 2121 and a light emission unit 2122.

In a case where the reflected light which is reflected from the object is incident as incident light, the lens 2111 forms an image of the incident light on a light receiving surface of the light receiving element 2112. Note that a configuration of the lens 2111 is arbitrary, and for example, the lens 2111 can be configured by a plurality of lens groups.

In a case where a light emission request is supplied from the control device 2011, the light receiving element 2112 supplies a light emission trigger to the LD 2121, and causes the light emission unit 2122 to emit irradiation light. Then, the light receiving element 2112 receives reflected light from the subject 2131, the subject 2132, and the like via the lens 2111.

The light receiving element 2112 includes a pixel array in which the SPAD pixels 100 according to any one of the first to tenth embodiments described above are two-dimensionally disposed in a matrix. The light receiving element 2112 receives reflected light from the subject 2131, the subject 2132, and the like, calculates a distance to the subject for each pixel on the basis of a pixel signal obtained as a result of the reception, and generates a distance image in which distance information to the subject as a calculation result is stored as a pixel value. The light receiving element 2112 supplies, as distance measurement data, the generated distance image to the control device 2011.

The LD 2121 is a laser driver that drives the light emission unit 2122, drives the light emission unit 2122 on the basis of the light emission trigger from the light receiving element 2112, and causes the light emission unit 2122 to emit irradiation light.

The light emission unit 2122 includes, for example, a vertical cavity surface emitting laser LED (VCSEL LED) and the like, and emits the irradiation light by driving of the LD 2121. As the irradiation light, for example, infrared light (IR light) having a wavelength in a range of approximately 850 nm to 940 nm is used.

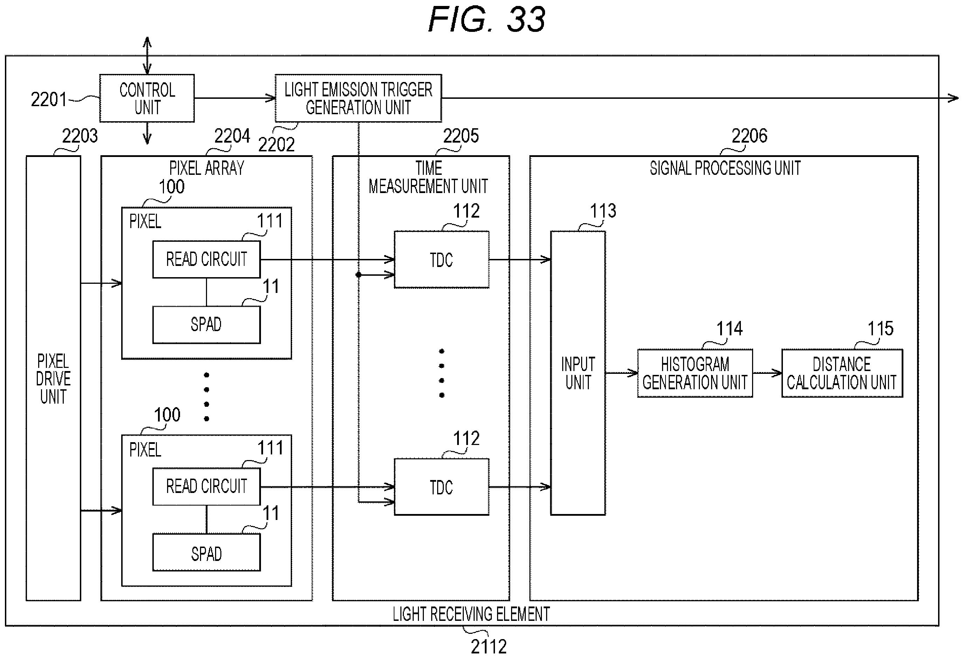

Fig. 33 is a block diagram illustrating a schematic configuration example of the light receiving element 2112.

The light receiving element 2112 includes a control unit 2201, a light emission trigger generation unit 2202, a pixel drive unit 2203, a pixel array 2204, a time measurement unit 2205, and a signal processing unit 2206.

The control unit 2201 controls the entire operation of the light receiving element 2112. For example, the control unit 2201 controls the light emission trigger generation unit 2202 on the basis of the light emission request from the control device 2011, and outputs the light emission trigger to the LD 2121. The light emission trigger which is output to the LD 2121 is also supplied to the time measurement unit 2205.

The pixel drive unit 2203 controls each SPAD pixel 100 by supplying a predetermined control signal to each pixel 100 (SPAD pixel 100) of the pixel array 2204. For example, the pixel drive unit 2203 performs control of setting, as active pixels, some of the plurality of SPAD pixels 100 which are two-dimensionally disposed in a matrix and setting, as inactive pixels, the remaining SPAD pixels 100, on the basis of the control from the control unit 2201. The active pixel is a pixel that detects incidence of photons, and the inactive pixel is a pixel that does not detect incidence of photons. Therefore, the pixel drive unit 2203 controls on/off of the light receiving operation of each SPAD pixel 100 of the pixel array 2204. Of course, all the SPAD pixels 100 of the pixel array 2204 may be set as the active pixels. The pixel signal generated by the active pixel in the pixel array 2204 is input to the time measurement unit 2205.

The pixel array 2204 includes the plurality of SPAD pixels 100 that detects incidence of photons and outputs, as a pixel signal, a detection signal PFout_Low indicating a detection result. Each SPAD pixel 100 includes an SPAD 11 and a read circuit 111, and has a pixel structure of any one of the first to tenth embodiments described above.

The read circuit 111 is a circuit that reads a timing at which photons are detected in the SPAD 11, from the detection signal PFout_Low. The configuration of the read circuit 111 is different from the configuration in any one of the first to tenth embodiments described above. For example, in the SPAD pixel 100 according to the first and second embodiments described above, the read circuit 111 includes the MOS transistor 12, the inverter 13, and the voltage conversion circuit 14. In the SPAD pixel 100 according to the third to tenth embodiments, the diode 241 provided as a current limiting circuit or a clamp circuit, the resistor 321, the polysilicon TFT 371, the MOS transistor 441, and the like are also included in the read circuit 111.

Note that, instead of the SPAD, an APD can be used as the light receiving element of each pixel 100 of the light receiving element 2112.

The time measurement unit 2205 includes a plurality of TDCs 112. Each TDC 112 generates a count value corresponding to a flight time from when the light emission unit 2122 emits light to when the active pixel receives light on the basis of the pixel signal supplied from the active pixel of the pixel array 2204 and the light emission trigger supplied from the light emission trigger generation unit 2202. The TDC 112 supplies the generated count value to the signal processing unit 2206.

The signal processing unit 2206 includes an input unit 113, a histogram generation unit 114, and a distance calculation unit 115.

The input unit 113 outputs the count value supplied from each TDC 112 of the time measurement unit 2205 to the histogram generation unit 114.

The histogram generation unit 114 creates a histogram of the flight time (count value) for each pixel until the reflected light is received on the basis of emission of the irradiation light that is repeatedly executed a predetermined number of times (for example, several to several hundred times) and reception of the reflected light. Data regarding the created histogram (hereinafter, referred to as histogram data) is supplied to the distance calculation unit 115.

The distance calculation unit 115 performs noise removal, histogram peak detection, and the like on the histogram data supplied from the histogram generation unit 114. Then, the distance calculation unit 115 calculates the flight time until the light emitted from the light emission unit 2122 is reflected by the subject and returned on the basis of a detected peak value of the histogram, and calculates the distance to the subject for each pixel from the calculated flight time. A distance image is generated on the basis of the calculated distance information, and is output to the control device 2011 as distance measurement data. Note that the histogram data may be generated not in units of pixels but in units of a plurality of pixels.

As described above, the light receiving element 2112 configured as described above is configured by stacking two substrates of the pixel substrate 21 (first substrate 21) and the logic substrate 51 (second substrate 51). The SPAD 11 of each SPAD pixel 100 and a part of the read circuit 111 are disposed on the pixel substrate 21. On the logic substrate 51, a logic circuit that performs signal processing on the pixel signal which is read by the read circuit 111 is formed. For example, the time measurement unit 2205 and the signal processing unit 2206 are formed as logic circuits on the logic substrate 51. Note that the signal processing unit 2206 may be omitted in the light receiving element 2112 and calculation of the signal processing unit 2206 may be performed by a digital signal processor (DSP) or the like provided at a subsequent stage of the light receiving element 2112.

### <15. Application Example to Moving Object>

The technique according to the present disclosure can be applied to various products. For example, the technique according to the present disclosure may be implemented as a device mounted on any type of moving object such as an automobile, an electric vehicle, a hybrid electric vehicle, a motorcycle, a bicycle, a personal mobility, an airplane, a drone, a ship, a robot, and the like.

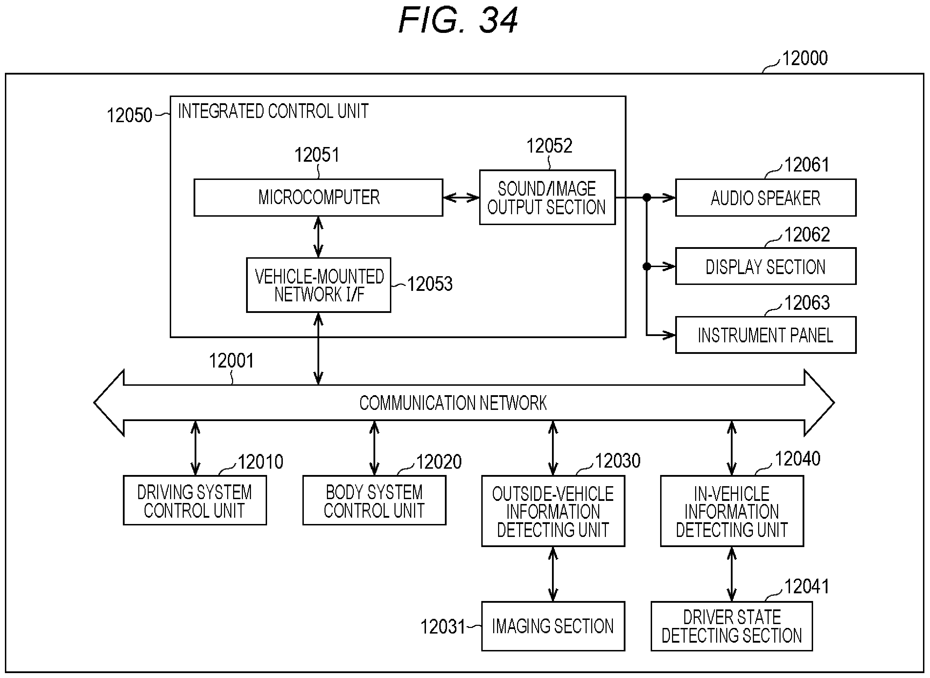

Fig. 34 is a block diagram illustrating a schematic configuration example of a vehicle control system as an example of a moving object control system to which the technique according to the present disclosure can be applied.

The vehicle control system 12000 includes a plurality of electronic control units connected to each other via a communication network 12001. In the example depicted in Fig. 34, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the outside-vehicle information acquired by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 34, an audio speaker 12061, a display section 12062, and an instrument panel 12063 are illustrated as the output device. The display section 12062 may, for example, include at least one of an on-board display and a head-up display.

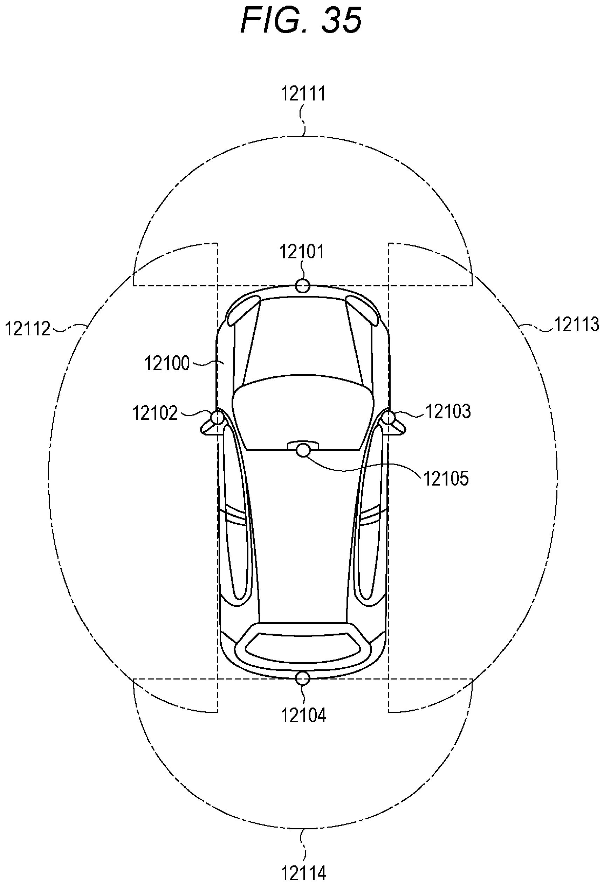

Fig. 35 is a diagram illustrating an example of an installation position of the imaging section 12031.

In Fig. 35, a vehicle 12100 includes imaging sections 12101, 12102, 12103, 12104, and 12105 as the imaging section 12031.

The imaging sections 12101, 12102, 12103, 12104, and 12105 are provided at positions such as, for example, a front nose, a sideview mirror, a rear bumper, a rear door of the vehicle 12100, and an upper portion of a front windshield in a vehicle interior. The imaging section 12101 provided to the front nose and the imaging section 12105 provided to the upper portion of the windshield within the interior of the vehicle obtain mainly an image of the front of the vehicle 12100. The imaging sections 12102 and 12103 provided on the sideview mirrors mainly obtain images of the sides of the vehicle 12100. The imaging section 12104 provided to the rear bumper or the back door obtains mainly an image of the rear of the vehicle 12100. The front images acquired by the imaging sections 12101 and 12105 are mainly used for detecting a preceding vehicle, a pedestrian, an obstacle, a traffic light, a traffic sign, a lane, and the like.

Note that Fig. 35 illustrates an example of imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technique according to the present disclosure can be applied has been described above. The technique according to the present disclosure can be applied to the imaging section 12031 and the like in the configuration described above. Specifically, for example, the configuration of the light receiving element 2112 or the ranging system 2001 in Fig. 32 can be applied to the imaging section 12031. The imaging section 12031 is used, for example, to detect an object around the vehicle 12100 and a distance to the object. By applying the technique according to the present disclosure to the imaging section 12031, it is possible to reduce a size of the imaging module, reduce the pixel size, and increase resolution. In addition, detection accuracy of an object around the vehicle 12100 and a distance to the object is improved. As a result, for example, a vehicle collision warning can be performed at an appropriate timing, and a traffic accident can be prevented.

Note that in the present description, a system means a set of a plurality of components (devices, modules (parts), and the like), and it does not matter whether or not all the components are in the same housing. Therefore, both of a plurality of devices housed in separate housings and connected via a network and a single device in which a plurality of modules is housed in one housing are systems.

In addition, the embodiment of the present disclosure is not limited to the above-described embodiments and various modifications may be made without departing from the gist of the present disclosure.

Note that the effects described in the present description are merely examples and are not limited, and effects other than those described in the present description may be provided.

Note that the technique of the present disclosure can have the following configurations.
(1) A light receiving element including:
   a first substrate on which an avalanche photodiode that converts received light into an electric signal and at least one element are formed, the element being included in a read circuit which outputs a pixel signal on the basis of the electric signal; and
   a second substrate on which a logic circuit is formed, the logic circuit being a circuit that processes the pixel signal which is read from the avalanche photodiode,
   the first substrate and the second substrate being stacked.
(2) The light receiving element according to (1),
   in which the first substrate includes a first semiconductor substrate and a first wiring layer,
   the second substrate includes a second semiconductor substrate and a second wiring layer,
   the first substrate and the second substrate are stacked by bonding the first wiring layer and the second wiring layer, and
   the at least one element is disposed between the first semiconductor substrate and the second semiconductor substrate.
(3) The light receiving element according to (2),
   in which the at least one element is disposed in the first wiring layer.
(4) The light receiving element according to (2) or (3),
   in which the at least one element is disposed in a region in which at least a part of the at least one element overlaps with the avalanche photodiode in a plan view.
(5) The light receiving element according to any one of (1) to (4),
   in which the at least one element is disposed at a position different from a position of the avalanche photodiode in a thickness direction of the first substrate.
(6) The light receiving element according to any one of (1) to (5),
   in which the first substrate includes a diode as the element.
(7) The light receiving element according to any one of (1) to (5),
   in which the first substrate includes a resistor as the element.
(8) The light receiving element according to any one of (1) to (5),
   in which the first substrate includes a resistor and a diode as the element.
(9) The light receiving element according to any one of (1) to (8),
   in which the first substrate includes a polysilicon TFT as the element.
(10) The light receiving element according to any one of (1) to (8),
   in which the first substrate includes a MOS transistor as the element.
(11) The light receiving element according to any one of (1) to (5),
   in which the first substrate includes a resistor, a diode, and a MOS transistor as the element.
(12) The light receiving element according to any one of (1) to (5),
   in which the first substrate includes, as the element, a MOS transistor as a constant current source.
(13) The light receiving element according to any one of (1) to (5),
   in which the first substrate includes, as the element, a MOS transistor as a constant current source and an inverter.
(14) The light receiving element according to any one of (1) to (5),
   in which the first substrate includes, as the element, a resistor, a diode, a MOS transistor as a clamp circuit, and a MOS transistor as a constant current source.
(15) The light receiving element according to (14),
   in which the resistor and the diode are symmetrically disposed in a pixel region, and the MOS transistor as the clamp circuit and the MOS transistor as the constant current source are symmetrically disposed.
(16) The light receiving element according to any one of (1) to (15), further including:
   a light shielding layer between the avalanche photodiode and the element.
(17) The light receiving element according to any one of (1) to (16),
   in which the read circuit is shared by a plurality of the avalanche photodiodes.
(18) A ranging system including:
   a lighting device that emits irradiation light; and
   a light receiving element that receives reflected light of the irradiation light, the reflected light obtained by being reflected by a predetermined object,
   in which the light receiving element includes
   a first substrate on which an avalanche photodiode that converts received light into an electric signal and at least one element are formed, the element being included in a read circuit which outputs a pixel signal on the basis of the electric signal, and
   a second substrate on which a logic circuit is formed, the logic circuit being a circuit that processes the pixel signal which is read from the avalanche photodiode,
   the first substrate and the second substrate being stacked.

### REFERENCE SIGNS LIST

- 11: SPAD
- 12: MOS transistor
- 13: Inverter
- 14: Voltage conversion circuit
- 15, 16: MOS transistor
- 21: First substrate (pixel substrate)
- 22: Semiconductor substrate
- 23: Wiring layer (sensor-side wiring layer)
- 24: On-chip lens
- 31: N-well
- 32: P-type diffusion layer
- 33: N-type diffusion layer
- 33A: Contact layer
- 34: Hole accumulation layer
- 34A: Contact layer
- 35: Pixel isolation portion
- 41: Contact electrode
- 42: Contact electrode
- 51: Second substrate (logic substrate)
- 52: Semiconductor substrate
- 53: Wiring layer (logic-side wiring layer)
- 100: SPAD pixel
- 241: Diode
- 321: Resistor
- 371: Polysilicon TFT
- 441: MOS transistor
- 901: Via formation layer
- 902: Polysilicon layer
- 903: Via formation layer
- 904: First metal wiring layer
- 905: Via formation layer
- 906: Bonding metal wiring layer
- 933: Resistor
- 1001: Polysilicon TFT
- 1031: Via formation layer
- 1032: Silicon layer
- 1033: Via formation layer
- 1131: MOS transistor
- 1132: Resistor
- 1133: Diode
- 2001: Ranging system
- 2011: Control device
- 2012: Light receiving device
- 2013: Lighting device
- 2012: Light receiving element
- 2113: Signal processing circuit
- 2122: Light emission unit
- M0: Metal light shielding layer
- M1: First metal wiring layer
- M2: Second metal wiring layer
- VE: Power supply voltage
- VRLD: Power supply voltage (anode voltage)
- VS: Cathode voltage

## Claims

1. A light receiving element comprising:
a first substrate on which an avalanche photodiode that converts received light into an electric signal and at least one element are formed, the element being included in a read circuit which outputs a pixel signal on a basis of the electric signal; and
a second substrate on which a logic circuit is formed, the logic circuit being a circuit that processes the pixel signal which is read from the avalanche photodiode,
the first substrate and the second substrate being stacked.

2. The light receiving element according to claim 1,
wherein the first substrate includes a first semiconductor substrate and a first wiring layer,
the second substrate includes a second semiconductor substrate and a second wiring layer,
the first substrate and the second substrate are stacked by bonding the first wiring layer and the second wiring layer, and
the at least one element is disposed between the first semiconductor substrate and the second semiconductor substrate.

3. The light receiving element according to claim 2,
wherein the at least one element is disposed in the first wiring layer.

4. The light receiving element according to claim 2,
wherein the at least one element is disposed in a region in which at least a part of the at least one element overlaps with the avalanche photodiode in a plan view.

5. The light receiving element according to claim 1,
wherein the at least one element is disposed at a position different from a position of the avalanche photodiode in a thickness direction of the first substrate.

6. The light receiving element according to claim 1,
wherein the first substrate includes a diode as the element.

7. The light receiving element according to claim 1,
wherein the first substrate includes a resistor as the element.

8. The light receiving element according to claim 1,
wherein the first substrate includes a resistor and a diode as the element.

9. The light receiving element according to claim 1,
wherein the first substrate includes a polysilicon TFT as the element.

10. The light receiving element according to claim 1,
wherein the first substrate includes a MOS transistor as the element.

11. The light receiving element according to claim 1,
wherein the first substrate includes a resistor, a diode, and a MOS transistor as the element.

12. The light receiving element according to claim 1,
wherein the first substrate includes, as the element, a MOS transistor as a constant current source.

13. The light receiving element according to claim 1,
wherein the first substrate includes, as the element, a MOS transistor as a constant current source and an inverter.

14. The light receiving element according to claim 1,
wherein the first substrate includes, as the element, a resistor, a diode, a MOS transistor as a clamp circuit, and a MOS transistor as a constant current source.

15. The light receiving element according to claim 14,
wherein the resistor and the diode are symmetrically disposed in a pixel region, and the MOS transistor as the clamp circuit and the MOS transistor as the constant current source are symmetrically disposed.

16. The light receiving element according to claim 1, further comprising:
a light shielding layer between the avalanche photodiode and the element.

17. The light receiving element according to claim 1,
wherein the read circuit is shared by a plurality of the avalanche photodiodes.

18. A ranging system comprising:
a lighting device that emits irradiation light; and
a light receiving element that receives reflected light of the irradiation light, the reflected light being obtained by being reflected by a predetermined object,
wherein the light receiving element includes
a first substrate on which an avalanche photodiode that converts received light into an electric signal and at least one element are formed, the element being included in a read circuit which outputs a pixel signal on a basis of the electric signal, and
a second substrate on which a logic circuit is formed, the logic circuit being a circuit that processes the pixel signal which is read from the avalanche photodiode,
the first substrate and the second substrate being stacked.
